(19) **Europäisches Patentamt**

**European Patent Office**

**Office européen des brevets**

(11) **EP 0 571 635 B1**

(12) **EUROPEAN PATENT SPECIFICATION**

(45) Date of publication and mention
of the grant of the patent:
**25.02.2004 Bulletin 2004/09**

(51) Int Cl.⁷: **H04R 3/04**, H03H 17/04

(21) Application number: **92924033.1**

(86) International application number:
**PCT/JP1992/001568**

(22) Date of filing: **30.11.1992**

(87) International publication number:
**WO 1993/011647 (10.06.1993 Gazette 1993/14)**

(54) **FREQUENCY CHARACTERISTIC COMPENSATION APPARATUS**

ANORDNUNG ZUR FREQUENZCHARAKTERISTIK- KOMPENSATION EINES SCHALLFELDES

DISPOSITIF SERVANT A COMPENSER DES CARACTERISTIQUES DE FREQUENCE D'UN CHAMP SONORE

(84) Designated Contracting States:
**DE FR GB**

(30) Priority: **28.11.1991 JP 34003791**

(43) Date of publication of application:
**01.12.1993 Bulletin 1993/48**

(73) Proprietor: **KABUSHIKI KAISHA KENWOOD
Shibuya-ku Tokyo 150 (JP)**

(72) Inventors:
 • **SATO, Makoto 302, Takakuraryo
58-5, Takakura-cho
Tokyo 192 (JP)**
 • **NAGASHIMA, Norio 101, Dai-7 Hara Bldg.
Tokyo 192 (JP)**

(74) Representative: **Patentanwälte
Leinweber & Zimmermann
Rosental 7
80331 München (DE)**

(56) References cited:
**EP-A- 0 198 293      EP-A- 0 209 931
EP-A- 0 285 316      EP-A- 0 398 536
GB-A- 2 080 068      JP-A- 59 161 907
JP-B- 61 058 049      JP-U- 58 037 217
JP-U- 60 189 128**

## EP 0 571 635 B1

**Description**

INDUSTRIAL APPLICATION FIELD

The present invention relates to an apparatus for compensating a sound field frequency spectrum, and more particularly to an apparatus for compensating a transmission frequency characteristic capable of obtaining a desired frequency response (hereinafter referred to as frequency characteristic) by a simple manipulation by a user.

PRIOR ART

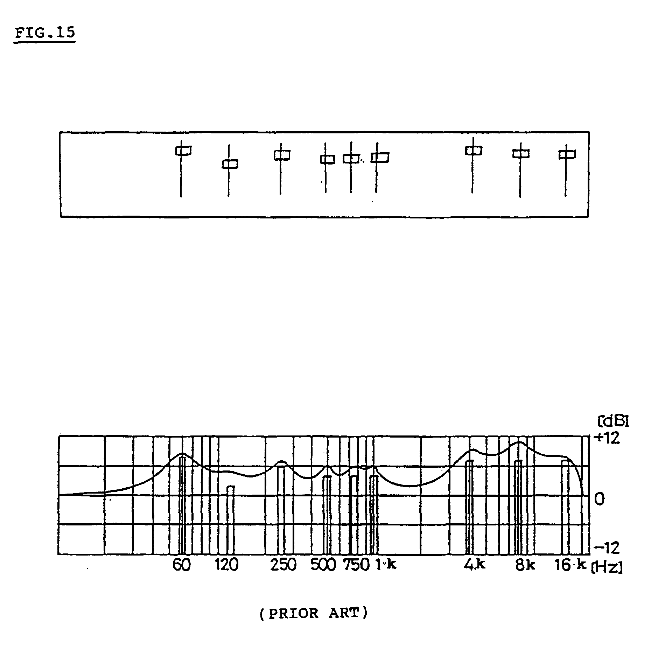

Recently, audio apparatuses with a built-in transmission frequency characteristic compensation apparatus or graphic equalizer have increased in number, the compensation apparatus adding a desired frequency characteristic compensation to a reproduced sound (original sound) of a CD apparatus or stereophonic apparatus to provide a sound quality preferred by a user. In setting the frequency characteristic by such a graphic equalizer, the gain of a filter of each band is changed using slide/volume as illustratively shown in Fig.15. A conventional graphic equalizer has a fixed center frequency point (e.g., 60 Hz, 120 kHz,..., 16 kHz) and peak factor (e.g., Q = 1.77) for each band, leaving only the gain adjustment to a user. There arise therefore a problem of a need of a number of filters as many as the number of setting frequency points and a problem of a difficulty of obtaining a desired flat frequency characteristic. To solve these problems, a system has been developed in which the values of resistors in each filter are changed by a user to adjust the peak factor (Q) and center frequency (fo), as disclosed, for example, in Japanese Utility Model Laid-open Publication No.03-97217.

However, it is not so easy for a user to set a desired frequency characteristic by properly adjusting these three parameters including the center frequency, peak factor, and gain, because these parameters interfere with each other. The proper adjustment of the three parameters requires a considerable skill.

EP-A-0 209 931 discloses an equalizer with adjustable band filters. In said equalizer, what is manually adjustable is the filter characteristics including a central frequency and a gain factor in each of a plurality of filter items. There is provided a processor means in form of a frequency analyzing unit which is adapted to apply a control signal to the band filters. What is further provided is memory means for storing filter coefficients.

GB-A-2,080,068 discloses a digital filter apparatus. In said apparatus, an initial transfer function must be obtained as a first step. What is provided in said apparatus is an arithmetic means for calculating the filter coefficients.

EP-A-0 398 536 discloses an apparatus for controlling acoustical transfer characteristics, wherein characteristics of filters are calculated on the basis of fuzzy logic. What is provided to this end is a memory section for storing various membership functions necessary for fuzzy interference.

SUMMARY OF THE INVENTION

It is an object of the present invention to provide a compensation apparatus capable of obtaining a desired sound field frequency spectrum with a simple manipulation by a user.

According to the invention, there is provided a frequency characteristic compensating apparatus according to claim 1. Preferred embodiments are claimed in the dependent claims.

In other words, there is provided setting means for allowing a user to set the gain at each setting frequency point. The setting means is similar to that of a conventional equalizer. The gain of each setting frequency point is processed by a predetermined algorithm to estimate the center frequencies, gains, and peak factors of several filters suitable for determining a desired frequency characteristic, to determine the filter coefficient parameters, and to store them in a coefficient table. In the frequency characteristic compensation apparatus, each filter is automatically set in accordance with, for example, weight coefficients stored in the coefficient table. The center frequencies, gains, and peak factors of several filters are not fixed but properly determined by using the algorithm.

In the process of setting a filter, the gain value for each setting frequency determined by a user is used as input data. The gain value is checked to determine the center frequency, gain, and peak factor of a first filter for the coarse approximation. The difference between the frequency characteristic of the first filter and the desired frequency characteristic is evaluated, for example, at a low band, middle band, and high band. Basing upon the maximum difference at these bands, the second filter is set. In this manner, several filters are set, and if a difference between the synthesized frequency characteristic of these filters and the desired frequency characteristic is within a desired allowance range over the full band, the filter setting is then completed.

A procedure of setting an optimum and small number of filters at high speed is important. In practicing the present invention, a provisional bandwidth is determined basing upon the desired frequency characteristic to decide the peak factor of a filter, and then fuzzy estimation is performed. The center frequency of the filter is first temporarily determined, and then the properness of this center frequency is evaluated while shifting it sequentially.

The structure of one embodiment of the present invention includes variable filter means including a plurality of filters capable of variably setting the filter coefficient parameters defining the center frequency, peak factor, and gain or attenuation, means for setting the gain at each setting frequency point, processor means for determining the center frequency, peak factor, and gain or attenuation of each filter to be set in accordance with the gain at each setting frequency point, memory means for storing coefficient parameters determined by the processor means, and means for supplying the coefficient parameters in the memory means to the variable filter means.

An example of a filter suitable for the present invention is an improved Bell type band-pass filter.

BRIEF DESCRIPTION OF THE DRAWINGS

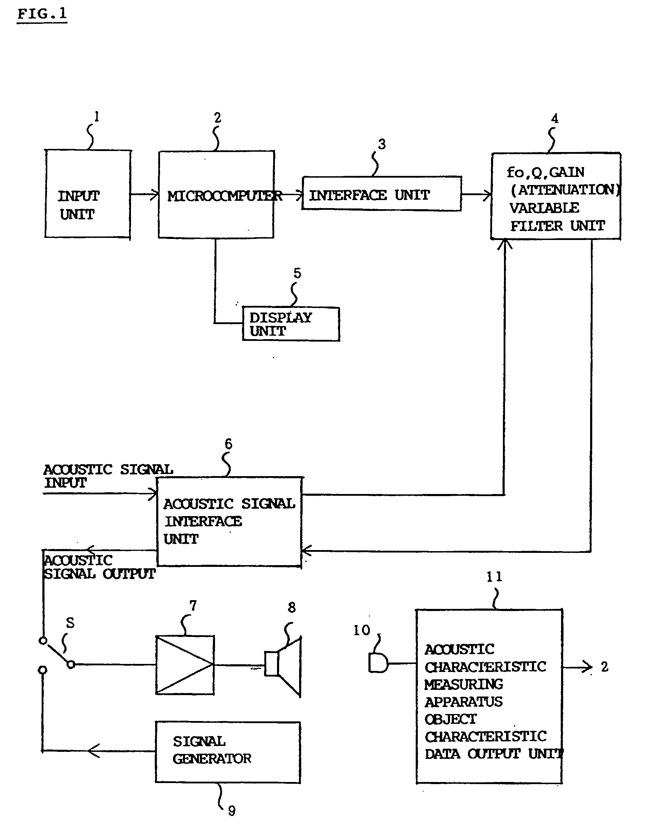

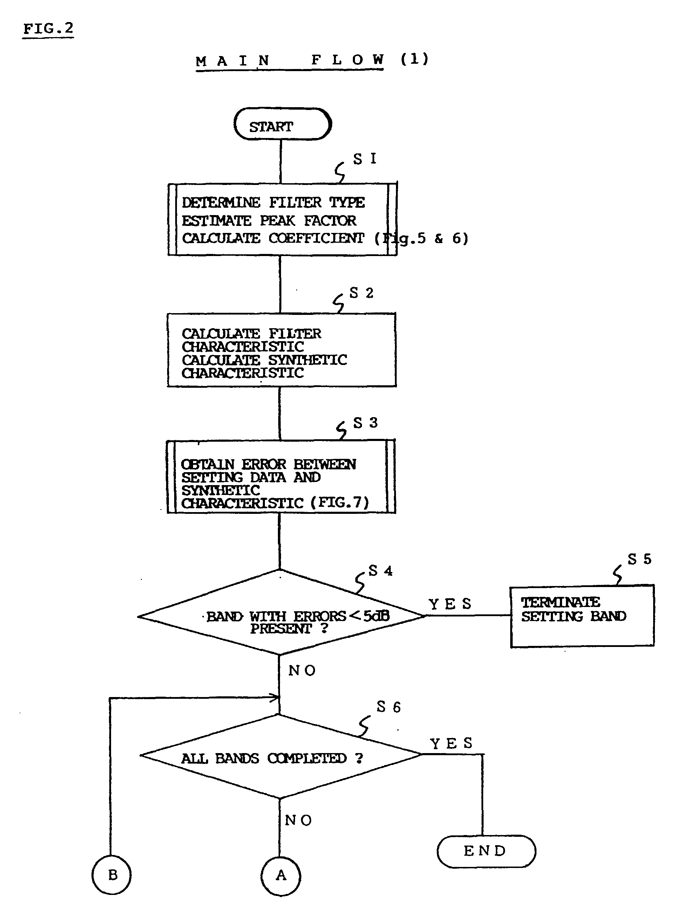

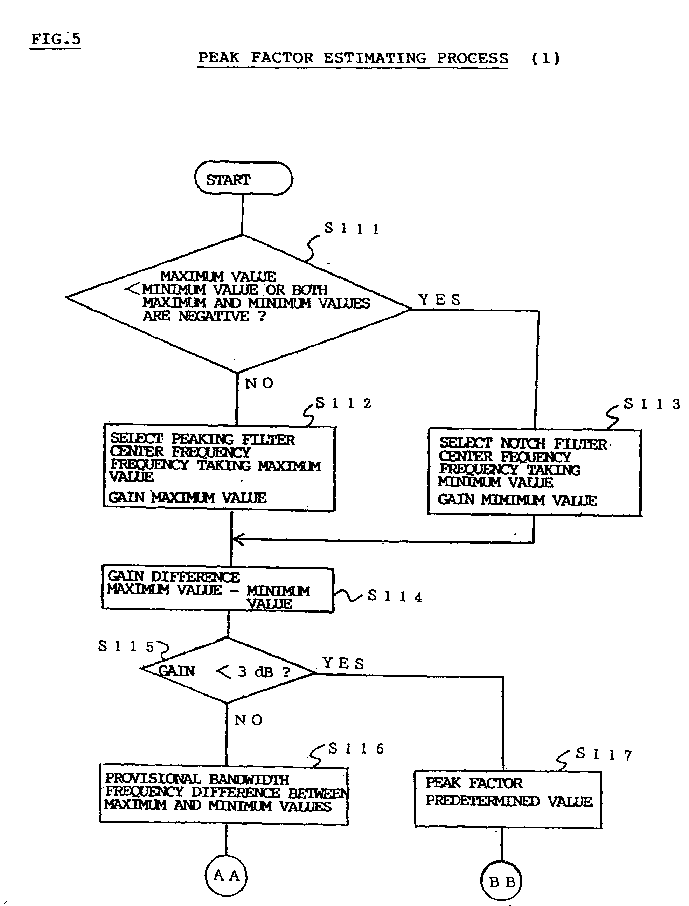

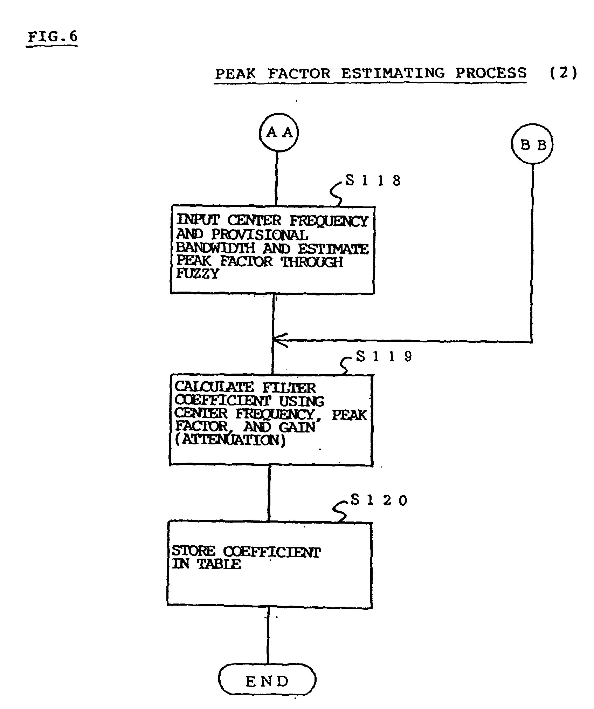

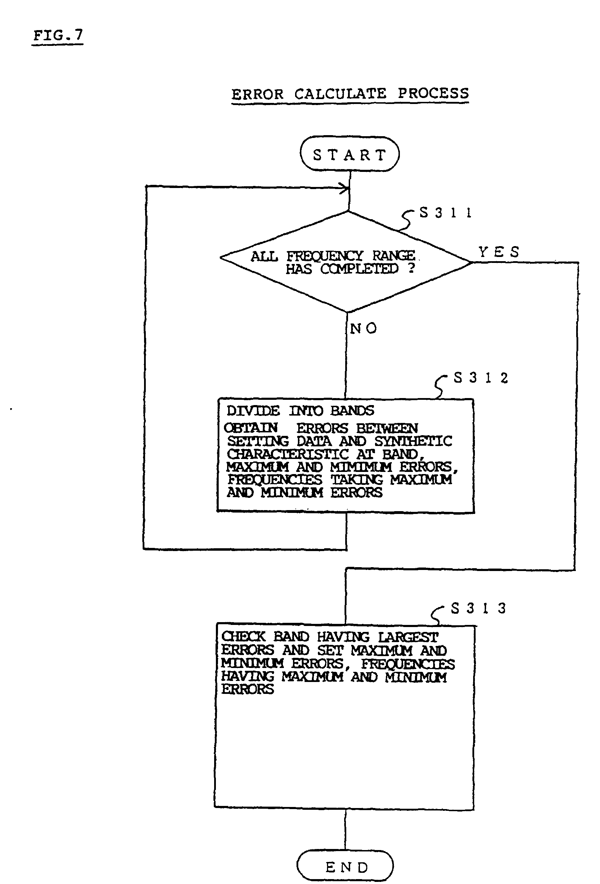

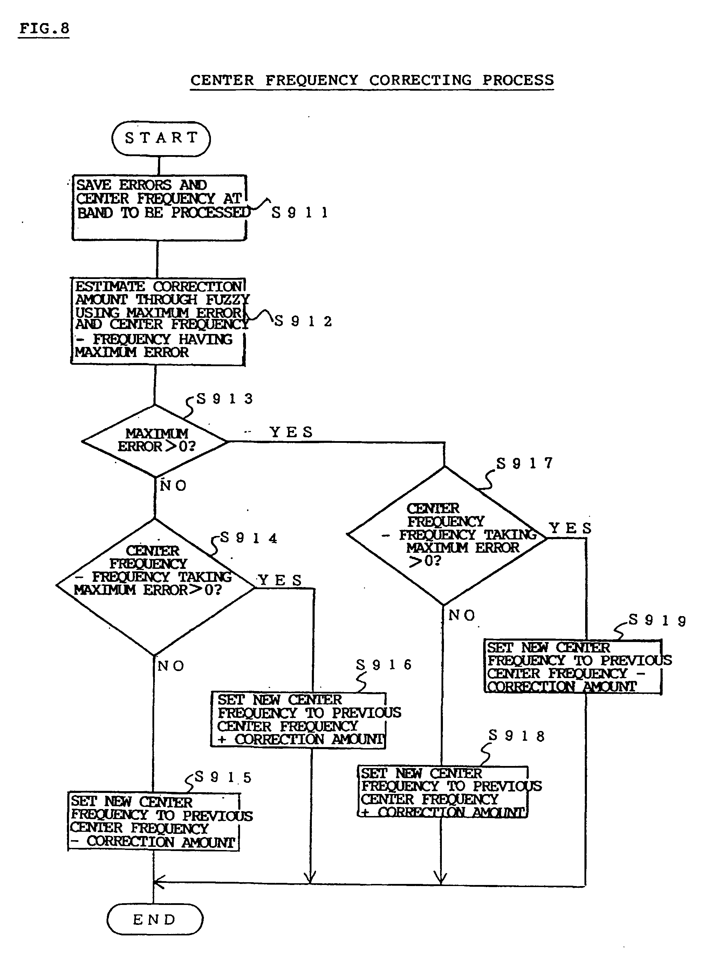

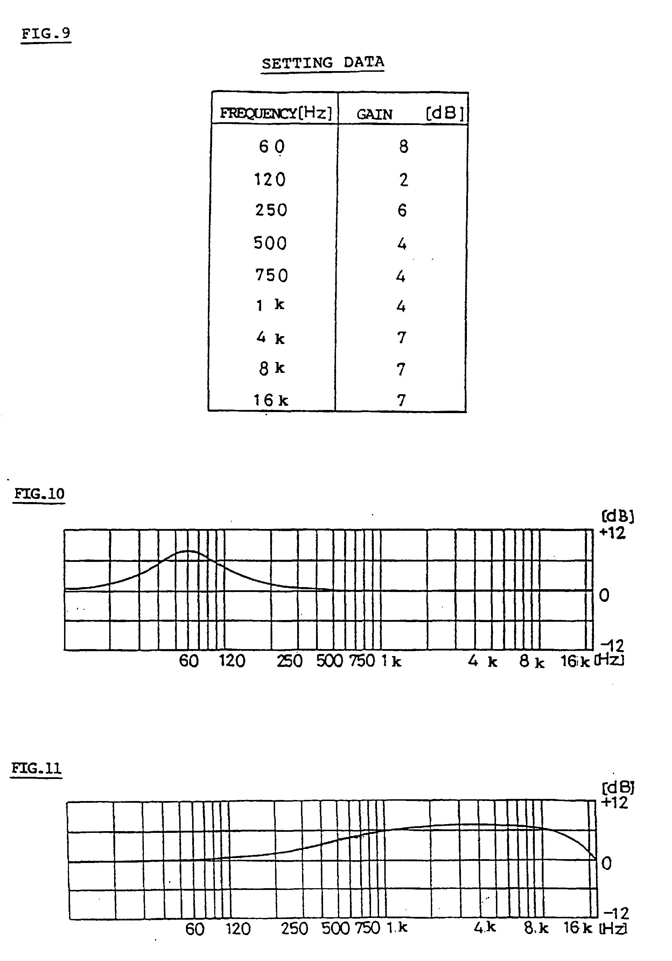

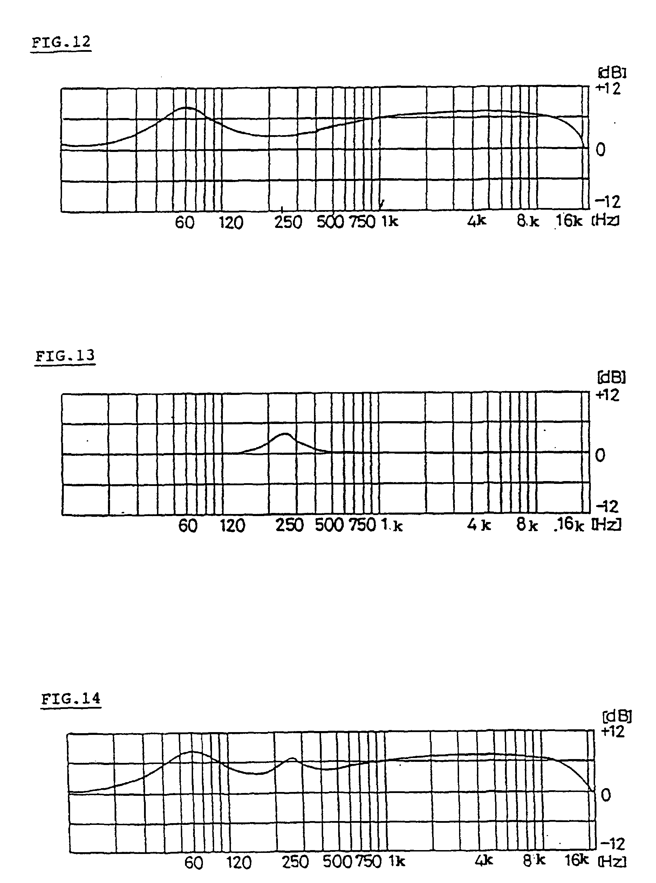

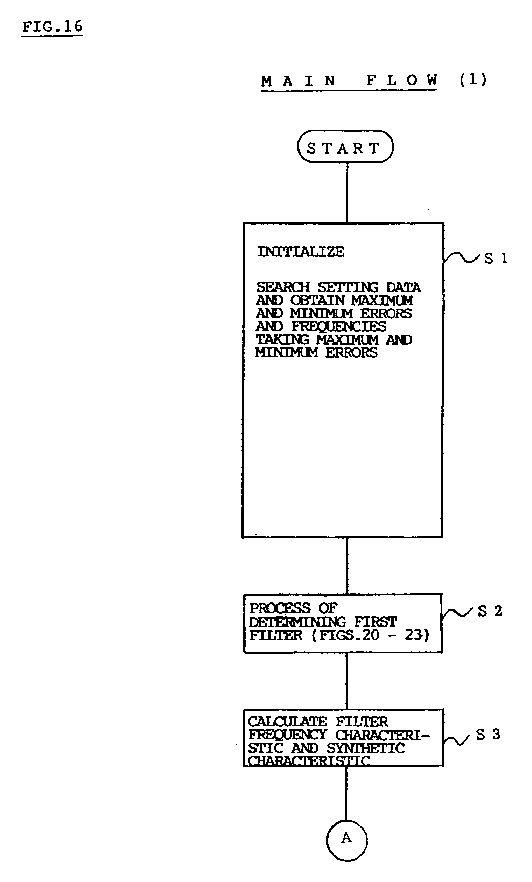

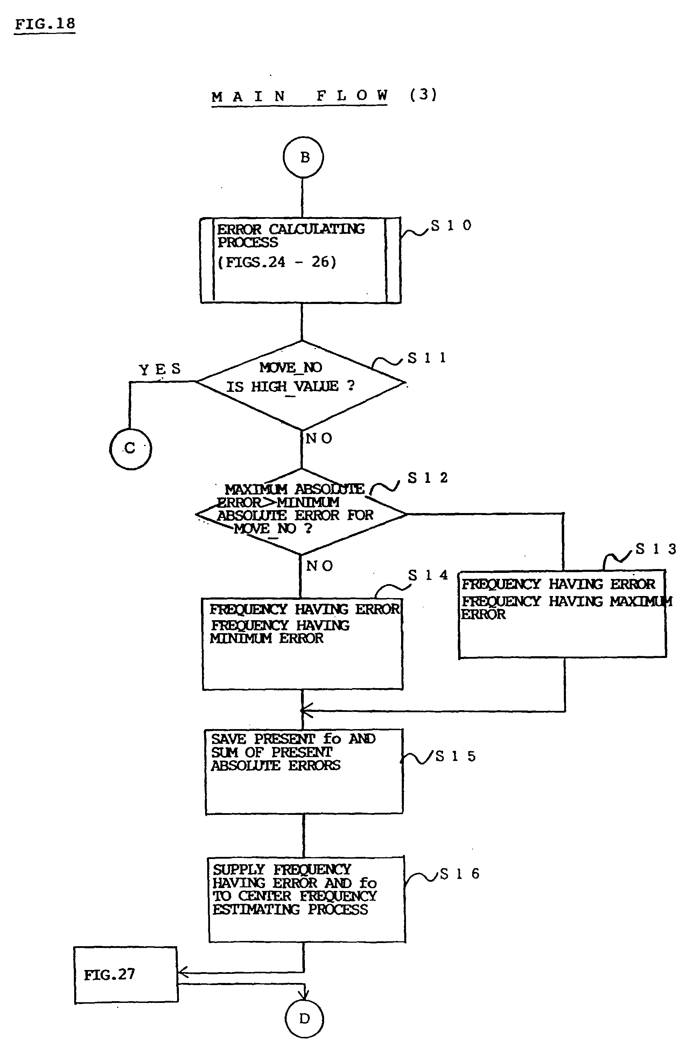

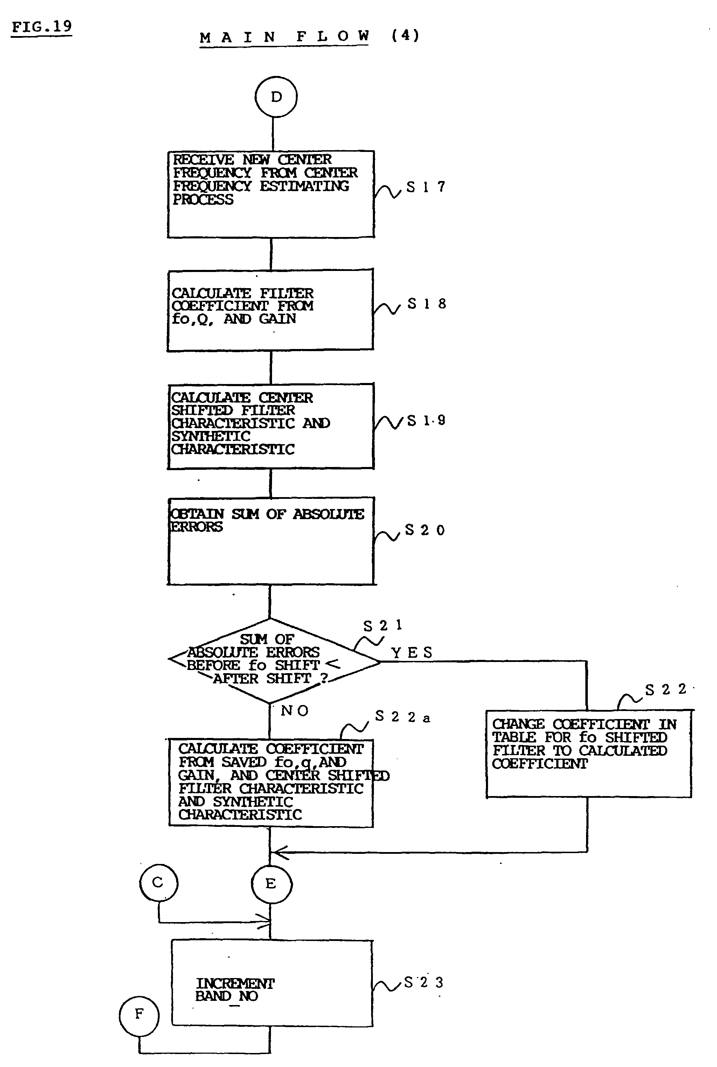

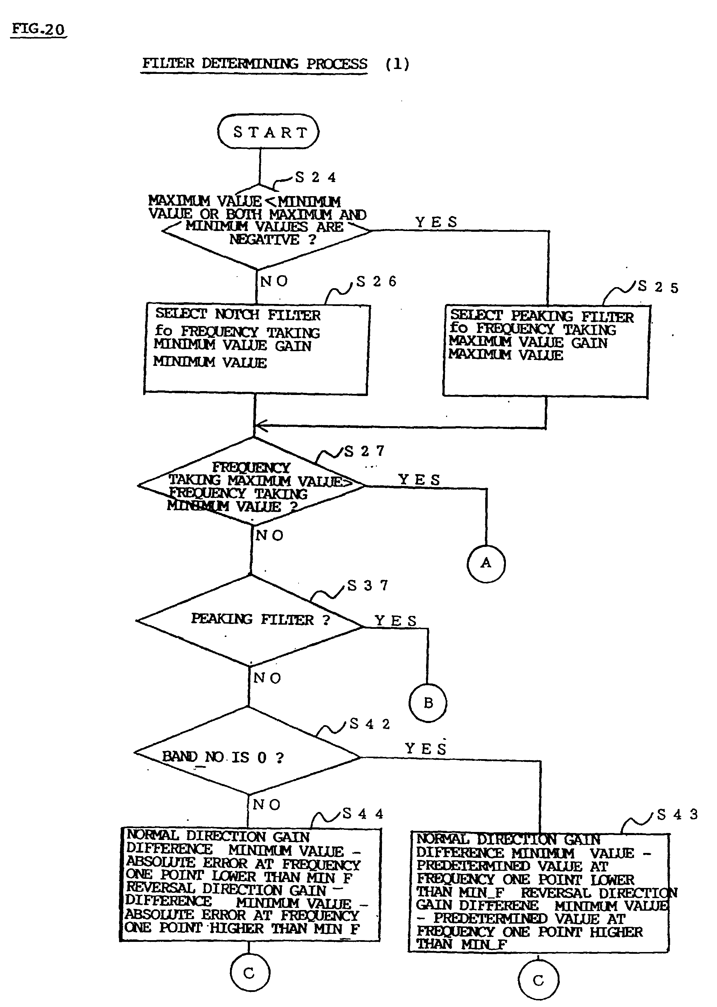

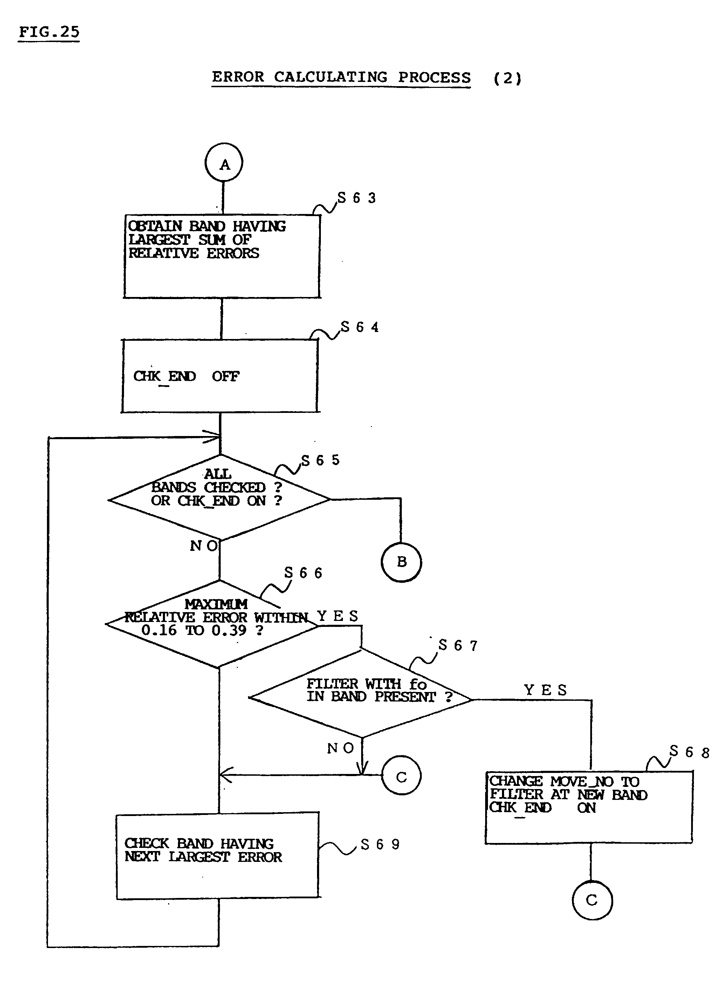

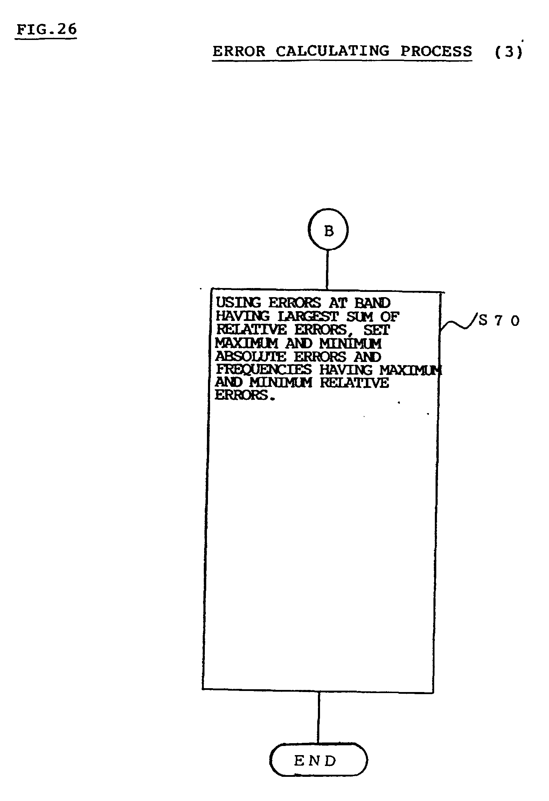

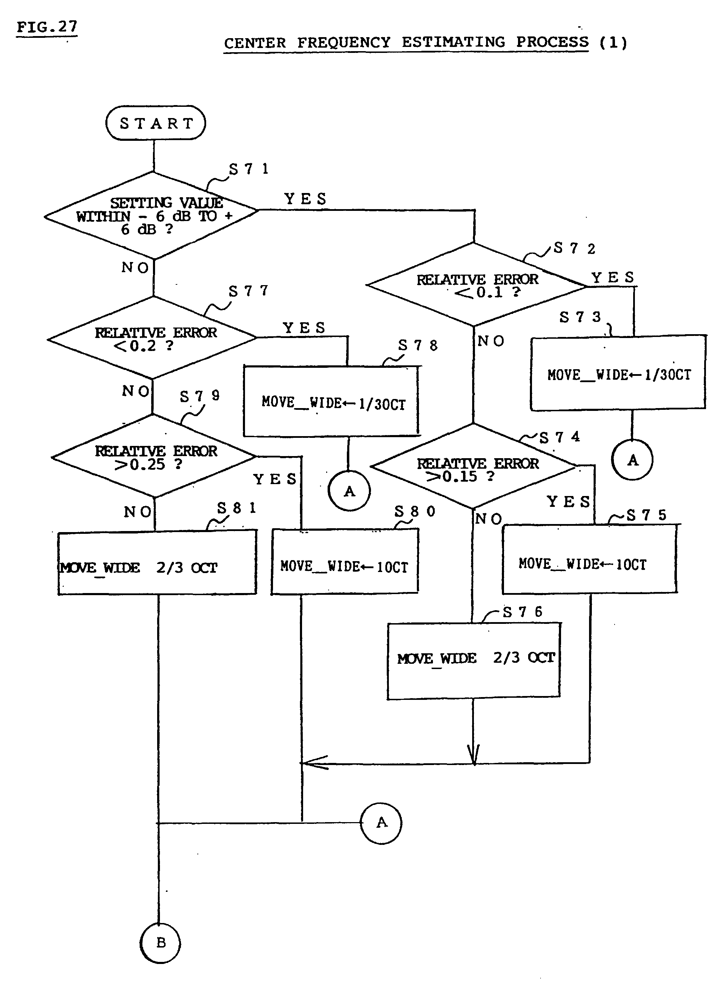

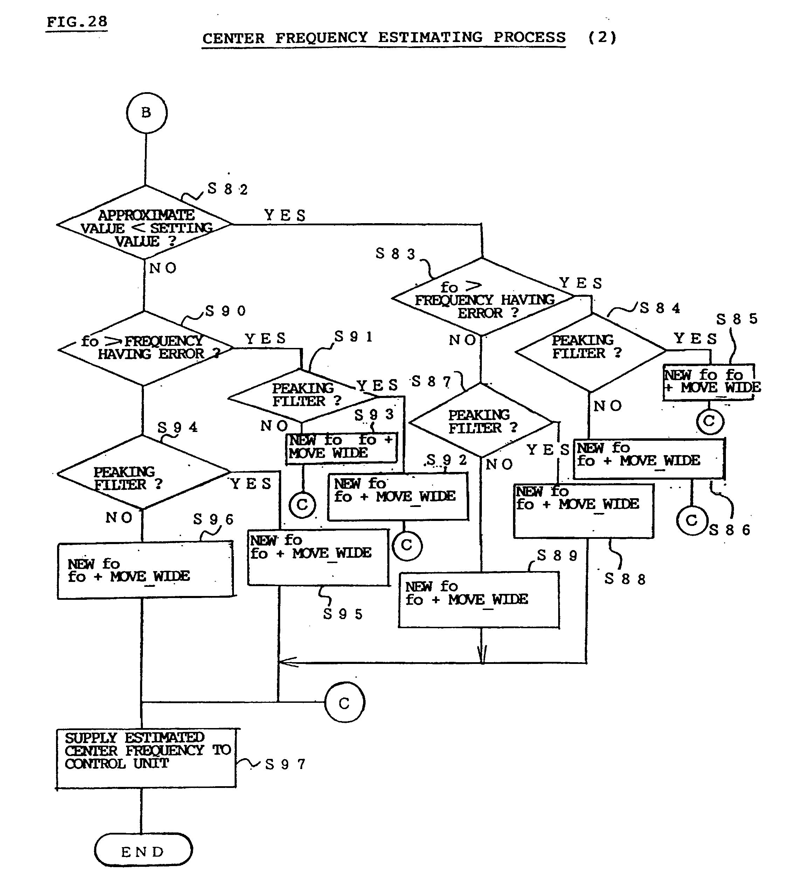

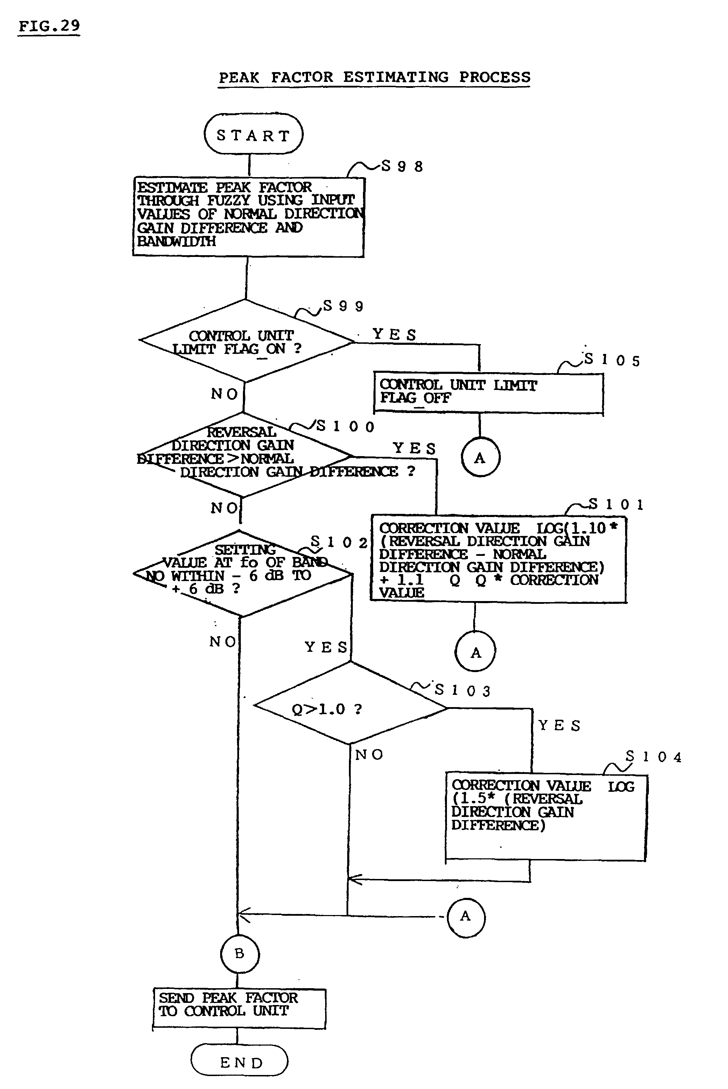

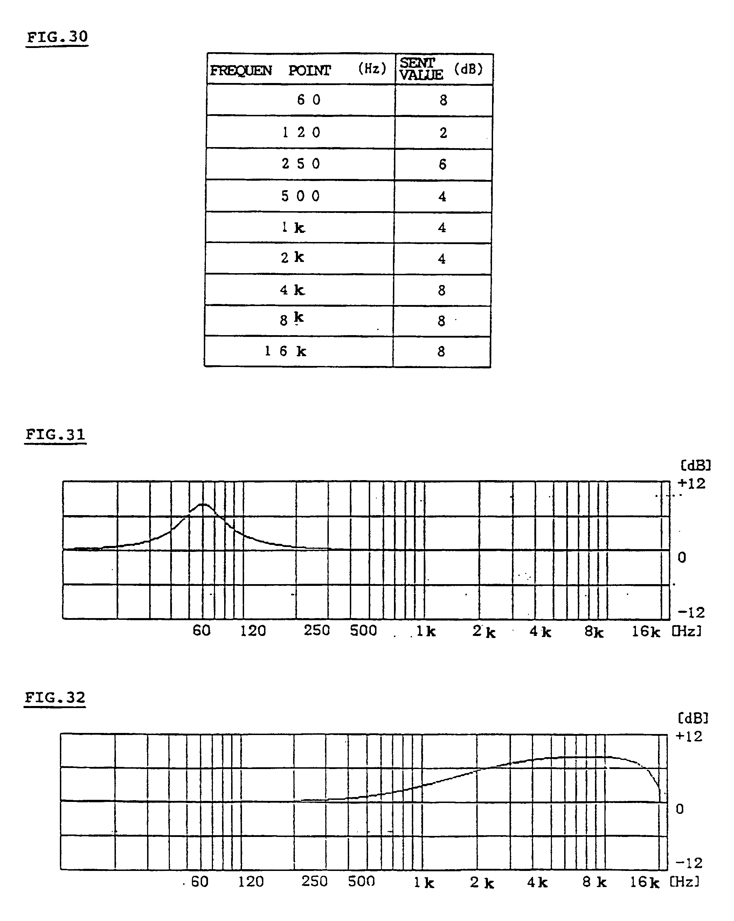

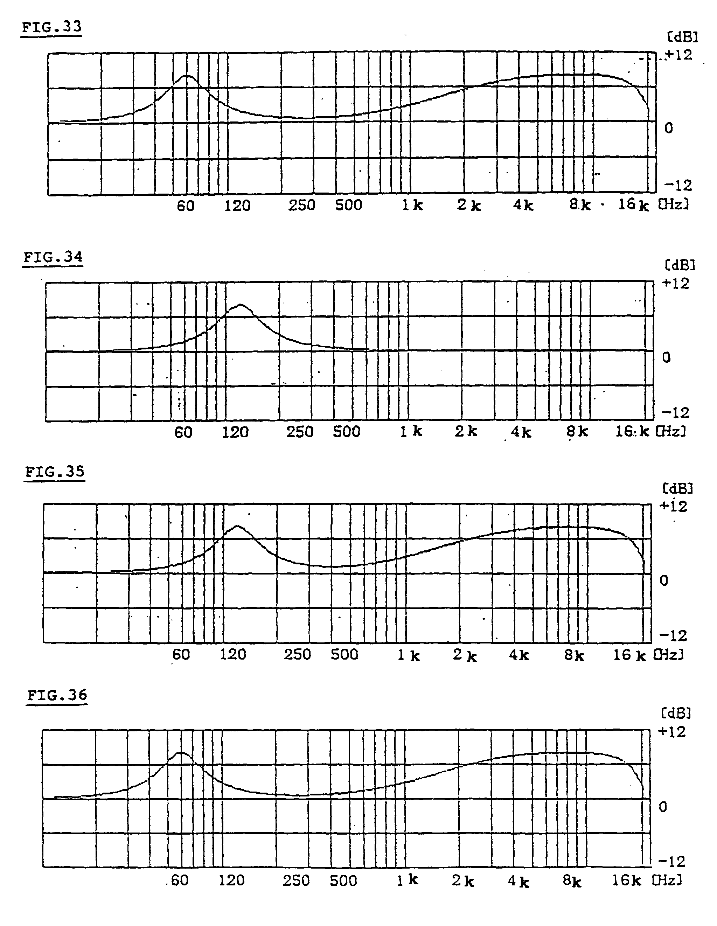

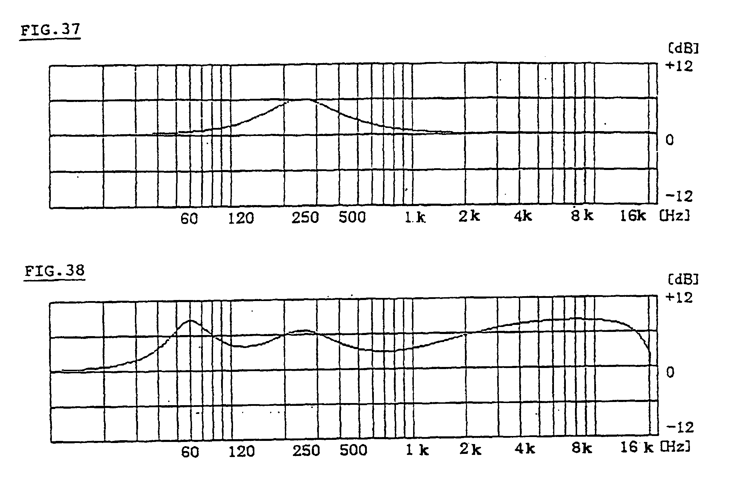

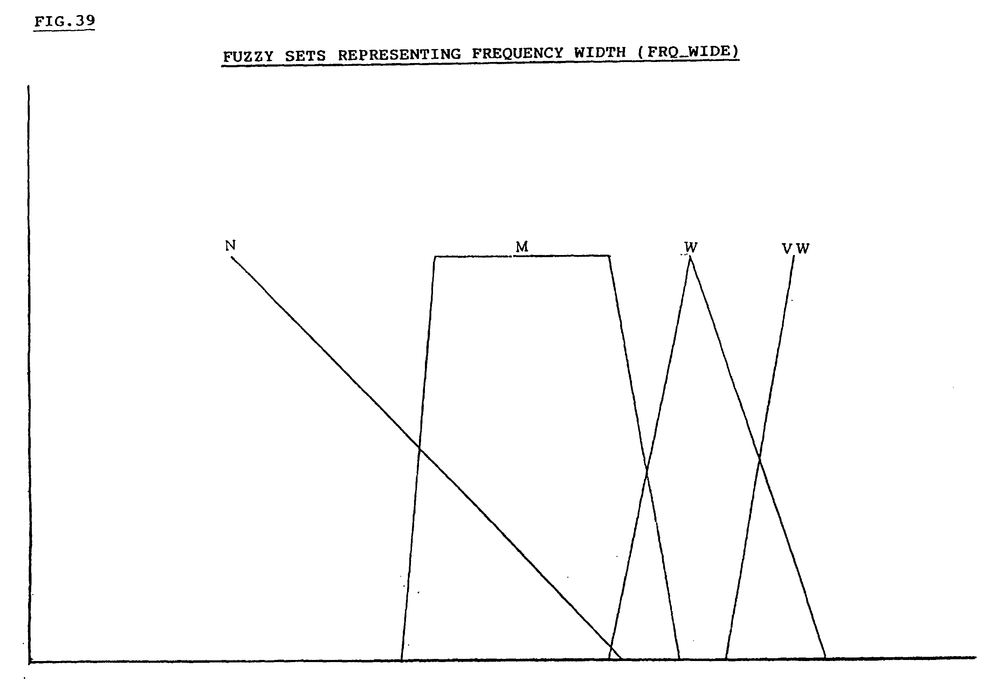

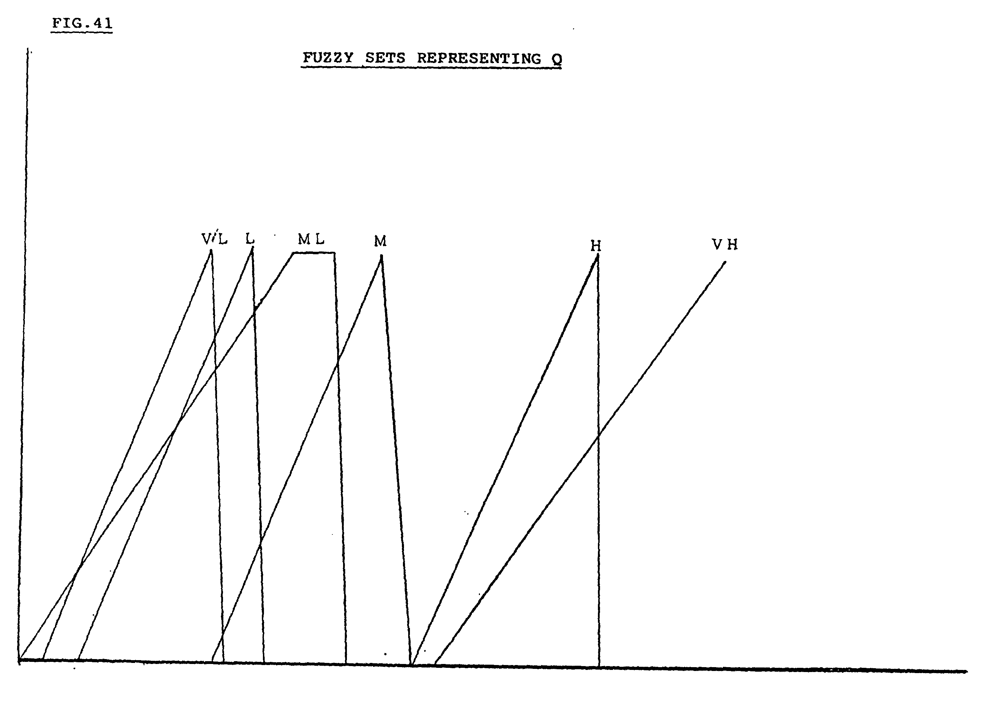

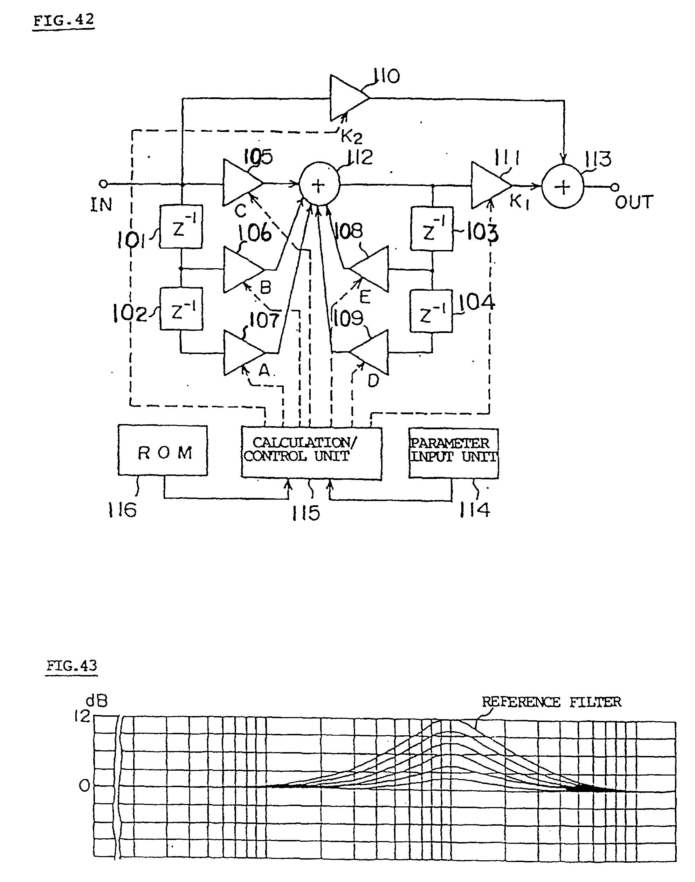

Fig.1 shows the structure of a first embodiment of the present invention. Figs.2 to 6 are detailed flow charts illustrating a filter setting process according to the first embodiment. Figs. 5 and 6 are detailed flow charts illustrating a peak factor estimating process according to the first embodiment. Fig.7 is a detailed flow chart illustrating an error calculating process according to the first embodiment. Fig.8 is a detailed flow chart illustrating a center frequency correcting process according to the first embodiment. Fig.9 shows examples of set data according to the first embodiment. Figs.10 and 11 show the frequency characteristics of the first and second set filters according to the first embodiment. Fig.12 shows the synthesized frequency characteristic (In the following named synthetic characteristic) of the first and second set filters. Fig.13 shows the frequency characteristic of the third set filter according to the first embodiment. Fig.14 shows the synthesized frequency characteristic of the first to third set filters. Fig.15 shows an example of the synthesized frequency characteristic of a conventional equalizer. Figs.16 to 24 are flow charts illustrating the filter setting process according to a second embodiment. Figs. 20 to 23 are detailed flow charts illustrating the filter determining process according to the second embodiment. Figs.25 and 26 are detailed flow charts illustrating the error calculating process according to the second embodiment. Figs.27 and 28 are detailed flow charts illustrating a center frequency estimating process according to the second embodiment. Fig.29 is a flow chart illustrating a peak factor estimating process according to the second embodiment. Fig.30 shows set data of the second embodiment. Figs.31 and 32 show the frequency characteristics of the first and second filters set in the second embodiment. Fig.33 shows the synthetic characteristic of the first and second set filters. Fig.34 shows the characteristic with the shifted center frequency of the first filter of the second embodiment. Fig.35 shows the synthetic characteristic of the characteristic of the first filter with the shifted center frequency and a second filter. Fig.36 shows the synthetic characteristic of the first set filter before the center frequency shift and the second set filter. Fig.37 shows the frequency characteristic of a third set filter according to a third embodiment. Fig.38 shows the synthetic characteristic of the first to third set filters. Figs. 39 to 41 show fuzzy sets of the fuzzy estimation. Fig.42 shows the characteristic synthesis of a digital filter used by the present invention. Fig.43 shows the characteristics of the digital filter shown in Fig.42.

DESCRIPTION OF THE EMBODIMENTS

FIRST EMBODIMENT

Fig.1 is a block diagram showing the structure of a compensation apparatus or equalizer according to an embodiment of the present invention. An input unit 1 is made of, for example, a slide volume board, key board, light pen, or the like. A user sets a desired frequency characteristic by entering data of gains at specific frequency points such as shown in Fig.9. A microcomputer 2 receives the entered data, calculates therefrom parameters including center frequencies, peak factors, and gain data, respectively for setting a proper variable filter unit, in accordance with a particular algorithm, and determines filter weight coefficients. The coefficients are stored in a coefficient table in a main memory of the microcomputer. Calculated correction characteristic is displayed on a display unit 5, and sent to the variable filter unit 4 via an interface unit 3. The variable filter unit 4 has a plurality of filters (maximum number of filters capable of being set = n) each being arbitrarily set with a center frequency ($f_o$), filter peak factor (Q), and gain or attenuation (G). The characteristic of each filter is determined by the coefficient parameters sent from the coefficient table via the interface unit 3. An acoustic signal interface unit 6 sends a reproduced signal (acoustic signal) from a CD or the like to the variable filter unit 4, and sends an acoustic signal subjected to a desired correction process at the variable filter unit 4 to an output amplifier or the like.

A sweep frequency signal or predetermined spectrum distribution signal may be supplied from a signal generator 9 to an amplifier 7 to drive a loudspeaker 8 and radiate sounds into a sound field. Sound signals picked up by a microphone 10 may be analyzed by an acoustic characteristic measuring apparatus/object characteristic data outputting apparatus 11 to obtain a sound field frequency spectrum.

Process Sequence

The processes to be executed by the microcomputer 2 for obtaining coefficient parameters of the filter group defining a desired frequency characteristic will be described in detail. When a user inputs setting data for the filter unit such as shown in Fig.9 as a desired frequency characteristic, from the input unit 1 to the microcomputer 2, the microcomputer 2 performs an initializing operation such as setting all n filters to 0 dB - flat, and starts the filter setting calculation process which will be detailed below. Figs.2 to 4 are main flow charts illustrating this process. In accordance with the setting data, one filter is first selected. A filter type (peak filter or notch filter) with a specific center frequency is selected, and the gain and peak factor of the filter of the selected filter are estimated (Step S1).

The determination of the filter type, estimation of the peak factor, and calculation of the coefficients at Step S1 are performed at processes illustrated in detail by the flow charts of Figs.5 and 6. The setting data is gains which take a positive or negative value such as + 8 dB and - 6dB. At Step S111 shown in Fig.5, all inputted setting data is checked to determine the maximum and minimum values (8 dB and 2 dB in the example of the setting data shown in Fig.9). It is judged whether one of the conditions that the absolute value of the maximum value is smaller than that of the minimum value and that both the maximum and minimum values are negative, is satisfied. If not satisfied, the filter type is determined as the peaking filter, the center frequency is determined as the frequency taking the maximum value, and the gain is determined as the maximum value of the setting data (Step S112). If satisfied, the filter type is determined as the notch filter, the center frequency is determined as the frequency taking the minimum value, and the attenuation is determined as the minimum value of the setting data (Step S113). After Step S112 or S113, a difference between the maximum and minimum values is calculated to obtain a gain difference (Step S114). In the example of the setting data shown in Fig.9, the gain difference is (8 - 2) dB = 6 dB. It is checked whether the gain difference is smaller than 3 dB (Step S115). If larger, a provisional bandwidth is obtained as the absolute value of a difference between the frequencies taking the maximum and minimum values (Step S116). If the gain difference is 3 dB, the - 3 dB bandwidth of the filter to be set, is set as the provisional bandwidth. filter to be set, is set as the provisional bandwidth. Using the center frequency and provisional bandwidth as input values, the peak factor or the - 3 dB bandwidth of the filter is estimated through fuzzy estimation or the like (Step S118). Next, filter weight coefficients are calculated from the center frequency, peak factor, gain (attenuation) (Step S119), and stored in the coefficient table (Step S120) to thereafter terminate the process. If the gain difference is judged smaller than 3 dB at Step S115 and the frequency characteristic is relatively flat as a whole, the peak factor is set to a predetermined value (Q = 0.25 or 0.5) without calculating it (Step S117), and thereafter executing the process starting from Step S119 shown in Fig.6.

After completion of the process at Step S1 shown in Fig.2, the frequency characteristic at the full band (60 Hz to 16 kHz) of the peaking filter with the coefficients obtained at Step S1 is calculated to obtain the synthetic characteristic with the (n - 1) other filters initialized to 0 dB - flat, and errors of the setting data relative to the synthetic characteristic are calculated (Step S3). The detail of this process is illustrated in Fig.7. A frequency range to be set is divided into a plurality of bands each band containing three frequency points of the setting data (for example, in Fig.9 one frequency band is constituted by 60 Hz-120Hz-250Hz). Errors at each band are obtained by a difference between the setting data and the synthetic characteristic. Namely, a difference between the synthetic characteristic inclusive of the estimated filter and the setting data is evaluated not at each frequency point but at each frequency band. First, it is checked whether all the frequency range to be set has been completed (Step S311). If not, the band division is effected to obtain the errors over the whole area of each band, the maximum and minimum error values, and the frequencies taking the maximum and minimum error values (Step S312), to thereafter return to Step S311. If all the frequency range has been completed at Step S311, the band having the largest error is checked to obtain the maximum and minimum error values and the frequencies having the maximum and minimum error values of the band having the largest error (Step S313). In estimating the second filter to be added to the first filter thus set, not the setting data used for the estimation of the first filter but the error values are considered for the further correction of errors between the synthetic characteristic and the setting data.

At Step S3 shown in Fig.2, the errors between the setting data and the synthetic characteristic are obtained. At Step S4 it is checked whether there is a band with all errors smaller than a predetermined value (in this example, 5 dB). If present, the filter setting for this band is terminated (Step S5), whereas if not present, it is checked whether all bands have been set (Step S6). If all bands have been set at Step S6, the process is terminated, whereas if not, it is checked whether the n filters have been set (Step S7). If the n filters have not been set still and if there is any filter in the filter unit which can be set, the type, peak factor, and coefficients of the second filter to be added, are calculated in the manner like Step S1 (Step S8). The maximum and minimum values and center frequency for this calculation are obtained from the errors of the divided band. If the n filters capable to be set in this embodiment have been already set at Step S7, it is not possible to add a filter. In this case, the center frequency of the set band filter is corrected in the manner to be described later with Fig.8 (Step S9), and the coefficients are calculated using the corrected center frequency (Step S10). Namely, if there is no filter to be added and set, the center frequency is corrected to make the synthetic characteristic to become near the setting data. If there is a filter to be added and set, the filter to be added is estimated at Step S8, and the set band characteristic of the second filter and the synthetic characteristic are calculated (Step S11). The errors of the calculated synthetic characteristic relative to the setting data are calculated in the manner like Step S3 (Step S12).

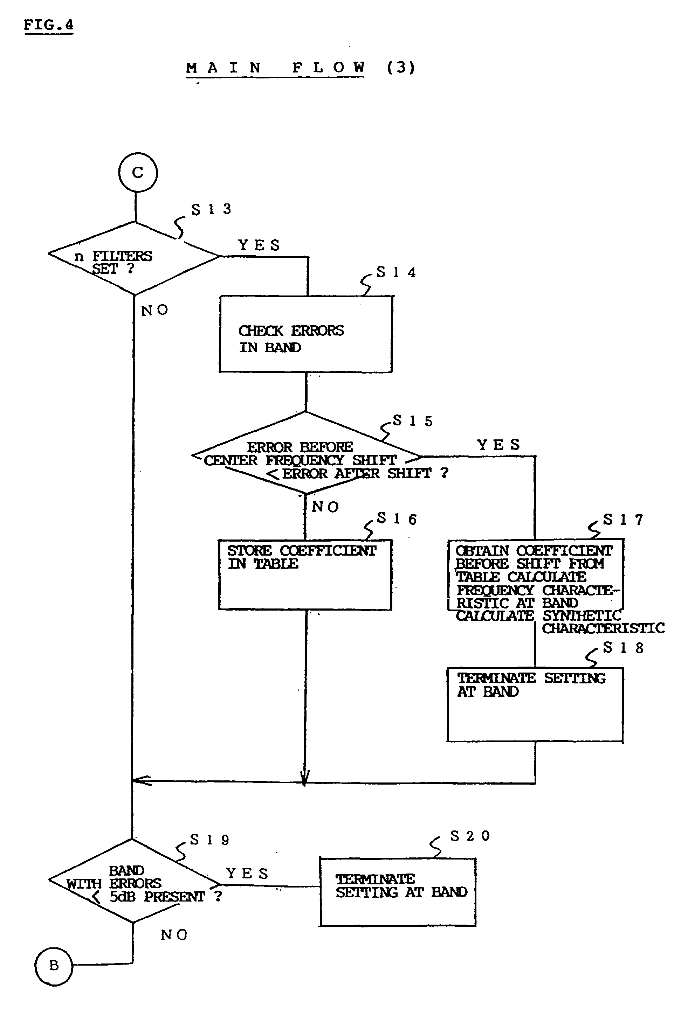

Next, as shown in Fig.4, it is checked whether the n filters have been set (Step S13). If set, the center frequency of the filter was corrected and the coefficients were calculated at Steps S9 and S10. The errors at the band which underwent the center frequency correction are examined to determine whether the errors before the center frequency correction are smaller than the errors after the center frequency correction (Step S15). If not, the filter coefficients are stored in the coefficient table (Step S16), whereas if smaller, the coefficients before the correction are obtained from the coefficient table to calculate the frequency characteristic of the set filter and the synthetic characteristic (Step S17). If all the filters have not been set at Step S13, it is checked for synthetic characteristic including the second filter calculated at Step S8, whether there is a band having all errors smaller than 5 dB (Step S19). If there is a band, the setting for this band is terminated (Step S20). If not, the process sequence returns to Step S6 shown in Fig.2. This loop continues until the errors of the synthetic characteristics of the estimated filters at all the bands become smaller than the predetermined value (5 dB) relative to the setting data.

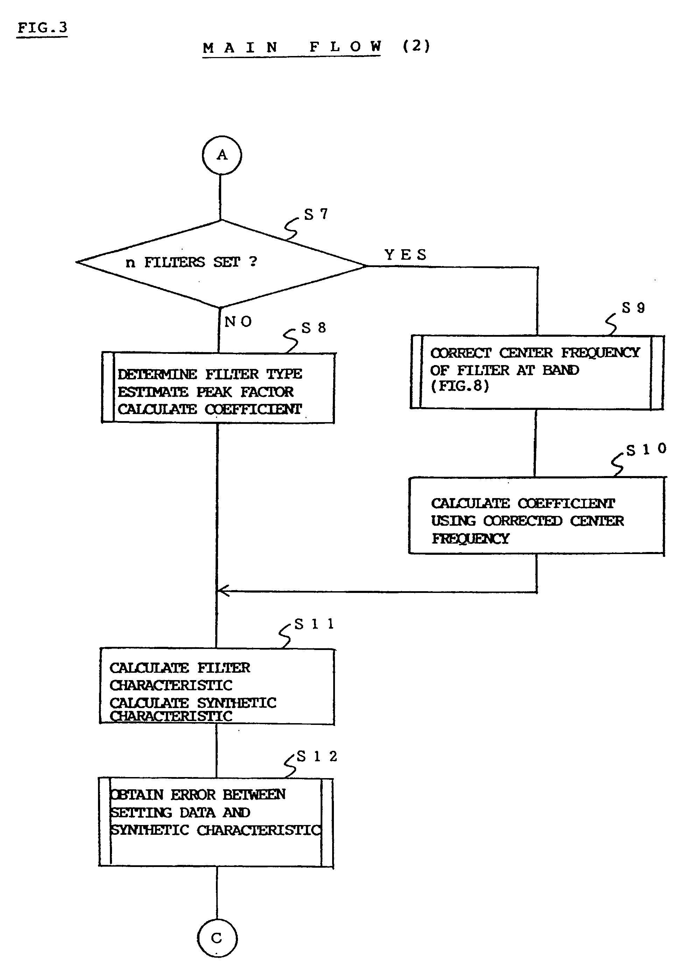

If all the n filters capable of being set have been used already and there is no filter to be added for changing the synthetic characteristic to have as near the setting values as possible, then the center frequency of the filter already set is corrected. The center frequency correction at Step S9 shown in Fig.3 is performed following the sequence shown in the flow chart of Fig.8. After storing the errors over the whole range of the band and the center frequency of the filter to which the center frequency correction is to be performed (Step S911), a correction amount is estimated through the fuzzy estimation to be described later, by using as the input value maximum error and the result of subtraction of (center frequency - frequency taking the maximum error) (Step S912). Namely, the center frequency of the filter set as the frequency taking the maximum value of the setting data is shifted to the frequency having the maximum error of the synthetic characteristic. It is judged whether the maximum error is positive or negative. If negative, it is checked whether the result of subtraction of the frequency taking the maximum error by the center frequency is positive or negative (Step S914). If negative, the new center frequency is set to the value obtained by subtracting the correction amount from the previous center frequency (Step S915), whereas if positive, the new center frequency is set to the value obtained by adding the correction amount to the previous center frequency (Step S916). If it is judged at Step S913 that the maximum error is positive, it is checked whether the result of subtraction of the frequency taking the maximum error by the center frequency is positive or negative (Step S917). If negative, the new center frequency is set to the value obtained by adding the correction amount to the previous center frequency (Step S918), whereas if positive, the new center frequency is set to the value obtained by subtracting the correction amount from the previous center frequency (Step S919).

The center frequency is corrected by the process sequence illustrated in Fig.8 as described above (Step S9). At Step S10, the filter coefficients are again calculated in accordance with the corrected center frequency. The synthetic characteristic is obtained using the filter characteristic calculated at Step S10. At Step S12, the errors of the synthetic characteristic relative to the setting data are obtained at Step S12. At Steps S14 to S18, it is checked which of the center frequencies before and after the correction is more suitable, and the filter coefficients calculated basing upon the more suitable one are selected.

With the above-described processes, the filter coefficients capable of providing a desired frequency characteristic designated by a user can be stored in the coefficient table. The microcomputer 2 sends the data in the coefficient table to the interface unit 3 to set the filters of the variable filter unit 4.

Example of Calculation

Given the setting data shown in Fig.9, the setting data is checked to obtain the maximum and minimum values and the frequencies taking the maximum and minimum values. In this example, the maximum value is 8 dB, the frequency taking the maximum value is 60 Hz, the minimum value is 2 dB, and the frequency taking the minimum value is 120 Hz. At Step S1 shown in Fig.2, the filter type becomes the peaking filter, the center frequency becomes 60 Hz, and the gain becomes 8 dB. Since the gain difference (8 - 2) = 6 dB is larger than 3 dB, the provisional bandwidth is determined as 120 - 60 = 60 Hz, and the center frequency is determined as 60 Hz. Using these values as the input values, the peak factor of the filter is estimated through the fuzzy estimation. This estimation provides the peak factor of 1.08. The filter coefficients are calculated from the center frequency 60 Hz, peak factor 1.08, and gain 8 dB. The calculated coefficients are stored in the coefficient table. The - 3 dB bandwidth of this filter is 60/1.08 = 55.6 Hz. The calculated synthetic characteristic is shown in Fig.10.

At Step S3 shown in Fig.2, the errors of the synthetic characteristic from the setting data are obtained. A single band is defined by the frequency range of three setting frequency points. In this example, the low band is 60-120-250 Hz, the middle band is 500Hz-750Hz-1 kHz, and the high band is 4kHz-8kHz-16 kHz. In each of these divided bands, the errors between the setting values and estimated filter characteristic are obtained.

The band having the largest error is the high band. Therefore, the second filter is estimated using the setting data at the high band. The setting data in the high band includes the maximum value (maximum error value) 7 dB, minimum value (minimum error value) 7 dB, frequency 4 kHz taking the minimum value, and frequency 4 kHz taking the maximum value. All the bands have not been set at Step S6 and only one filter has been set at Step S7 (n is the maximum number of filters capable of being set). Therefore, the peak factor estimation process shown in the flow chart of Figs.5 and 6 is performed at Step S8. After this process, the set values are the center frequency 4 kHz, peak factor 0.25, and gain 7 dB. The frequency characteristic of the set filter is shown in Fig.11.

Fig.12 shows the synthetic characteristic of the frequency characteristic of the second filter calculated at Step S11 and shown in Fig.11, the frequency characteristic of the first filter shown in Fig.10, and the frequency characteristic of the remaining (n - 1) filters of 0 dB - flat.

Next, at Step S12, the errors between the setting data shown in Fig. 9 and the synthetic characteristic shown in Fig.12 are obtained. Assuming that there remains a filter capable of being set at Step S13, the band having the largest error of 5 dB or larger is the middle band (Step S19). Therefore, the third filter is estimated using the setting data of the middle band. The data used for the third filter includes therefore the maximum value 4 dB, minimum value 0 dB, frequency 350 Hz taking the maximum value, and frequency 500 Hz taking the minimum value. The process sequence returns from Step S19 back to Step S6. Since all the bands have not been set and only two filters have set, the estimation process for the third filter is performed at Step S8 detailed in Figs.5 and 6. At this process, the estimated values are the center frequency 250 Hz, peak factor 1.18, and gain 4 dB. The frequency characteristic of this filter is shown in Fig.13.

Fig.14 shows the synthetic characteristic of the first to third estimated filters obtained at Steps 11 and 12 and the characteristic of the remaining (n - 3) filters. The errors at all the bands obtained at Step S12 are 5 dB or smaller (Step S19), and so the setting at all the bands is terminated (Step S6 - END). In this example, at the time when the setting is completed, the coefficients data for three filters have been stored in the coefficient table. The remaining filters have the characteristic initialized to 0 dB. The succeeding operation of the microcomputer is the same as described previously.

SECOND EMBODIMENT

In the first embodiment, the peak factor (Q) of each selected filter is estimated from the center frequency and provisional bandwidth (a difference between frequencies taking the maximum and minimum gains of the setting data). In the second embodiment, the peak factor (Q) is estimated while taking into consideration a difference between the maximum or minimum gain value and the gain value at a setting frequency point near the maximum or minimum gain value. The structure of the apparatus of the second embodiment is the same as that shown in Fig.1, and the main flow of the filter setting process is shown in Figs.16 to 19.

Main flow (Figs.16 to 19)

At Step S1 shown in Fig.16, all the setting data is checked to determine the maximum and minimum values, and frequency (MAX_F) taking the maximum value, and frequency (MIN_F) taking the minimum value. If the maximum and minimum values are present at a plurality of setting frequency points, the lowest frequency points are used as MAX_F and MIN_F. Assuming the setting data is present at nine setting frequency points such as shown in Fig.30, the maximum value is 8 dB, the minimum value is 2 dB, the frequency MAX_F taking the maximum value is 60 Hz, and the frequency MIN_F taking the minimum value is 120 Hz. Next, the filter determining process is executed (Step S2). The detail of Step S2 is shown in Figs.20 to 23 which will be described later.

At Step S2, using the determined maximum and minimum values and MAX_F and MIN_F, the filter coefficient parameters including the center frequency (fo), peak factor (Q), and gain or attenuation (GAIN) are determined. The detail of this determining process will be described later with reference to the flow charts of Figs.20 to 23. In accordance with the coefficient parameters determined at Step S2, the filter coefficients of the filter identified by a setting filter number BAND_NO are calculated and stored in the coefficient table. In the example of the setting data shown in Fig. 30, as the result of the filter determining process at Step S2, there are obtained the coefficient parameters of the first filter BAND_NO = 0 which are fo = 60 Hz, Q = 1.75, and GAIN = 8 dB.

Next, the frequency characteristic of the set filter BAND_NO = 0 and the synthetic characteristic are calculated (Step S3). For the example of the setting data shown in Fig.30, an example of the synthetic characteristic of the first filter BAND NO = 0 is shown in Fig.31.

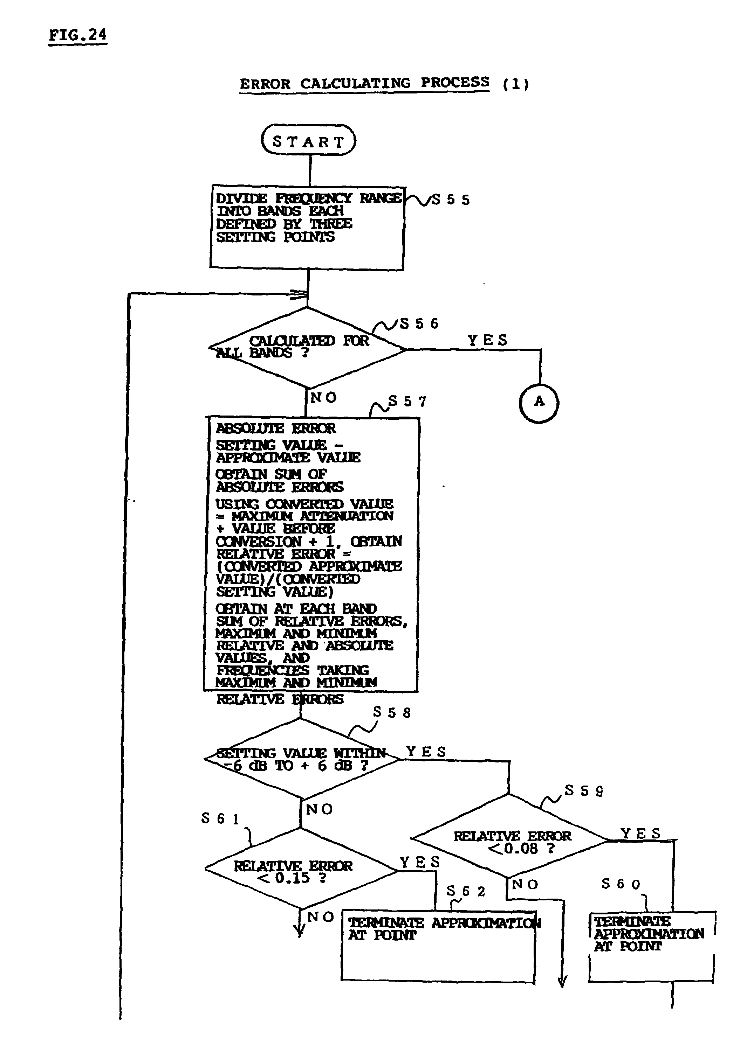

Next, at Step S4 (detail of which is shown in Figs.24 to 26), an error calculating process is performed using the synthetic characteristic of the set filter and the setting data. At the error calculating process, the characteristic values at the setting frequency points of the calculated synthetic characteristic are used as approximate values. Next, the synthetic characteristic is divided into bands each defined by three setting frequency points, and the errors in each band are evaluated. As the errors between the setting values and approximate values, the following values are obtained.

$$\text{Absolute value} = \text{setting value} - \text{approximate value} \qquad (1)$$

$$\text{Converted value} = \text{maximum attenuation value} + \text{value before conversion} + 1 \qquad (2)$$

$$\text{Relative error} = 1.0 - (\text{converted approximate value})/(\text{converted setting value}) \qquad (3)$$

The maximum attenuation value is the maximum attenuation value capable of being set to a filter. In this embodiment, this value is - 12 dB. The absolute error given by the equation (1) is a magnitude of the error between the setting value and the synthetic characteristic (approximate value) at a setting frequency point. The relative error given by the equation (3) is a value used for evaluating the error basing upon a ratio of the magnitudes of the setting value and approximate value relative to the maximum attenuation value (- 12 dB) calculated by the equation (2). For example, if the approximate value is 6 dB and the setting value is 5 dB, it becomes that the absolute error = 5 - 6 = - 1 dB, the converted setting value = 12 + 5 + 1 = 18, the converted approximate value = 12 + 6 + 1 = 19, and the relative error = 1.0 - 19/18 = - 0.056.

It is then checked if the setting value is within the range from - 6 dB to + 6 dB at each setting frequency point. If within the range and the setting frequency characteristic is relatively flat and if the relative error is 0.08 or smaller, the approximation at the setting frequency point is terminated. On the other hand, if the setting value is outside the range from - 6 dB to + 6 dB and if the relative error is 0.15 or smaller which is a relatively large reference, the approximation at the setting frequency point is terminated. A band having the maximum sum of relative errors at setting frequency points is then obtained to set the maximum value to the maximum absolute error, the minimum value to the minimum absolute error, MAX_F to the setting frequency taking the maximum relative error, and MIN_F to the setting frequency taking the minimum relative error. In the determination of the first filter BAND_NO = 0, the setting data is used. However, in the determination of the second and following filters, the errors between the synthetic characteristic of the set filters and the desired equalizer characteristic are used. At Step S4, the errors are calculated, and values necessary for the following Steps are set.

For the example of the setting data shown in Fig.30, it becomes that the maximum value is 8 dB, minimum value is 8 dB, MAX_F is 8 kHz, and MIN_F is 8 kHz, the detail of this process being described later.

Next, in the filter setting calculating main flows, BAND_NO is incremented to "1" indicating the second filter. It is then checked whether the approximation at all setting frequency points has been completed (Step S5). If completed, the coefficients of the filter in the variable filter unit are changed in accordance with the coefficients in the coefficient table (Step S6). In this case, the filter setting process is terminated. If not completed, the filter determining process is executed for the filter BAND_NO = 1 in the manner like Step S2. At Step S7, in the example of the setting data shown in Fig.30, there are obtained fo = 8 kHz, Q = 0.5, and GAIN = 8 dB as the coefficient parameters of the second filter BAND_NO = 1, basing upon the minimum and maximum values, MAX_F, and MIN_F. Next, the frequency characteristic of the filter BAND_NO = 1 and the synthetic characteristic are calculated (Step S8). The frequency characteristic of the second filter BAND-NO = 1 in the example of the setting data shown in Fig.30 is shown in Fig.32, and the synthetic characteristic of the filters BAND_NO = 0 and BAND_NO = 1 is shown in Fig.33.

After setting the first and second filters, the center frequency of the first or second filter set to the setting frequency point having the maximum gain, minimum attenuation, or maximum error, is shifted, and it is checked whether the frequency shift provides a better result. To this end, MOVE_NO of the filter BAND_NO whose center frequency is shifted is set to HIGH_VALUE (Step S9). This setting is performed so as to allow the judgement of center frequency shift at the following Steps. The error calculating process is executed for the synthetic characteristic shown in Fig.33 and the setting characteristic (Step S10). In the example shown in Fig.30, the result of the error calculating process shows that the maximum value = 6 dB, minimum value = 0 dB, MAX_F = 250 Hz, MIN_F = 60 Hz, and the sum of the absolute errors is 16 dB. MOVE_NO is set to "0" to shift the center frequency of the first filter. It is then checked whether MOVE_NO is HIGH_VALUE (Step S11). If MOVE_NO Is HIGH_VALUE, the process sequence jumps to Step S23. If not, it is judged whether the absolute value (e.g., 3) of the maximum absolute value (3 dB) of the filter identified by MOVE_NO is larger than the absolute value (e.g., 8) of the minimum absolute value (- 8 dB) (Step S12). If larger, the setting frequency taking the maximum error is used as a frequency f* having an error (Step S13). If not larger, the setting frequency taking the minimum error is used as a frequency f* having an error (Step S14). In this manner, the frequency f* having the maximum error is determined within the band at which the center frequency is shifted.

Next, the present center frequency fo and the sum of the absolute errors obtained by the error calculating process are saved (Step S15). The frequency having an error and fo are passed to a center frequency estimating process shown in Fig.27 (Step S16). In the center frequency estimating process, a new fo is estimated from the setting value, approximate value, and relative error at the received frequency f* having the maximum error, and the new fo is returned to the control process. The detail of the center frequency estimating process will be described later with reference to Fig.27.

In the example of the setting data shown in Fig.30, the frequency f* having the maximum error is 250 Hz, and the initial center frequency is fo = 60 Hz. In this case, the new center frequency estimated at the center frequency estimating process shown in Fig.27 is fo = 120 Hz. The filter determining calculating flow receives this new fo from the center frequency estimating process (Step S17). The filter coefficients are calculated from the new f0, peak factor Q and GAIN of the filter identified by MOVE-NO (Step S18). The characteristic of the shifted filter identified by MOVE_NO and the synthetic characteristic are calculated (Step S19). For the example of the setting data shown in Fig.30, the characteristic of the filter whose center frequency was shifted to fo = 120 Hz from the first filter identified by MOVE_NO = 0 shown in Fig.31 is shown in Fig.34, and the synthetic characteristic is shown in Fig.35.

Next, the sum of the absolute errors is obtained from the synthetic characteristic shown in Fig.35 and the desired setting characteristic (Step S20). In the example of the setting data shown in Fig.30, the sum of absolute errors of the synthetic characteristic with the shifted fo becomes 25. It is then checked whether the sum of absolute errors after shifting to fo is smaller than before shifting (Step S21). If smaller, the content of the coefficient table is changed to the calculated coefficients of the filter MOVE_NO with the shifted fo (Step S22). If not smaller, the coefficients are again calculated from the previously saved fo, Q and GAIN of the filter MOVE-NO. Next, the characteristic of the shifted filter MOVE_NO and the synthetic characteristic are calculated (Step S22_a). In the example of the setting data shown in Fig.30, the sum of absolute errors calculated at Step 10 is 15 and the sum of absolute errors calculated at Step S20 is 25. Therefore, the coefficients and characteristic are again calculated in accordance with fo = 60 Hz, Q = 1.75, and GAIN = 8 dB before shifting. The synthetic characteristic with the initial fo is shown in Fig.36.

Next, BAND_NO is incremented (Step S23). The process sequence jumps to Step S5. In the example of the setting data shown in Fig.30, BAND_NO is incremented to "2" to set the third filter and the process sequence jumps to Step S5. Since the approximations at 250 Hz, 500 Hz, and 1 kHz have not been completed as yet, Step S7 and following Steps are executed to set the third filter. Using the maximum value = 6 dB, minimum value = 0 dB, MAX_F = 250 Hz, and MIN_F = 60 Hz obtained at Step S10, the above-described process is executed to thereafter obtain fo = 250 Hz, Q = 0.82, and GAIN = 6 dB as the parameters of the third filter. Then, Step S8 is executed to calculate the synthetic characteristic of the first to third filters. The characteristic of the first filter BAND_NO = 2 is shown in Fig.37, and the synthetic characteristic of the first to third filters is shown in Fig.38.

After Step S9, the error calculating process is executed (Step S10). Since MOVE-NO remains HIGH_VALUE, the process sequence jumps to Step S23 whereat BAND_NO is incremented and thereafter it is checked whether the approximations at all setting frequency points have been completed. Next, in accordance with the coefficients in the coefficient table, the coefficients of the filters in the variable filter unit are changed (Step S6). In this manner, the filter setting calculating process is terminated.

Filter Determining Process (Figs.20 to 23)

The detail of the filter determining process at Step S2 will be described with reference to the flow charts of Figs.20 to 23. In the filter determining process, the center frequency fo, gain GAIN, and peak factor Q of the filter are determined using the gain at each given frequency point. In the filter determining process, it is checked whether one of the conditions that the absolute maximum value is smaller than the absolute minimum value and that both the maximum and minimum values are negative, is satisfied (Step S24). If not satisfied, the peaking filter is selected as the filter type, the center frequency (fo) is set to the frequency MAX_F taking the maximum value, and the gain (GAIN) is set to the maximum value (Step S26). On the other hand, if satisfied, the notch filter is selected, the center frequency (fo) is set to the frequency MIN_F taking the minimum value, and the attenuation is set to the minimum value (Step S25). In the example shown in Fig.30, the maximum value is 8 dB, the minimum value is 2 dB, the peaking filter is selected, the center frequency is 60 Hz, and the gain is 8 dB.

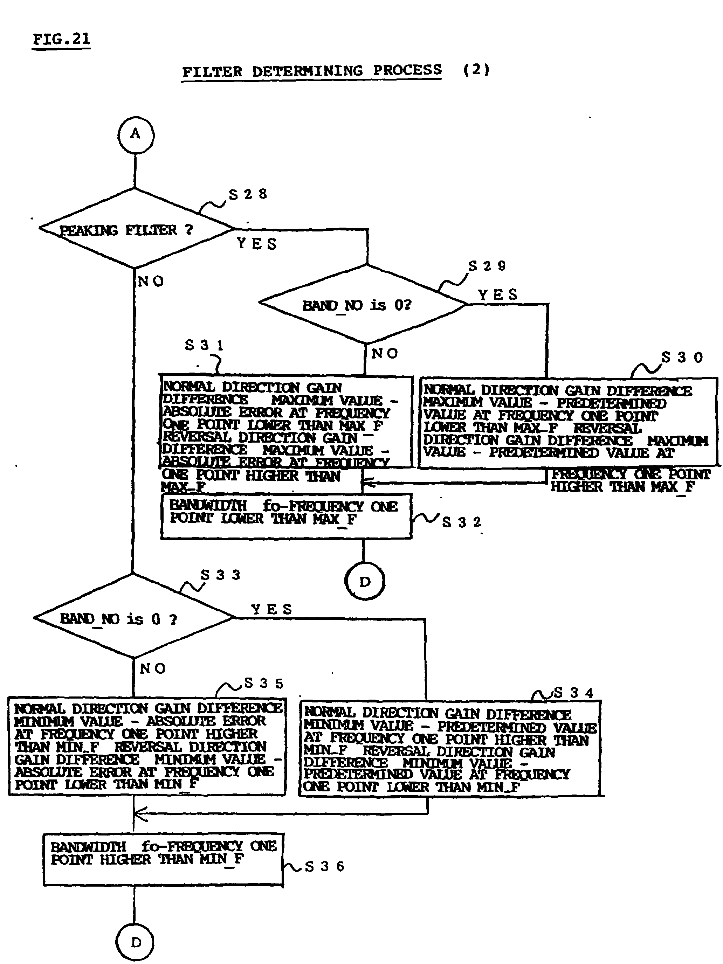

Next, at Step S27, it is checked whether the frequency taking the maximum value is higher than the frequency taking the minimum value (MAX_F > MIN_F). If higher, the process sequence advances to the flow chart shown in Fig. 21 to check whether the peaking filter was selected (Step S28). If selected, it is checked whether BAND_NO of the filter is "0" (Step S29). If "0", it means that the first filter is to be set. A normal direction gain difference is set to the value obtained by subtracting from the maximum value the setting value (e.g., in the case of MAX_F = 1 kHz, the setting data at 500 Hz) at the frequency one point lower than MAX_F, and a reversal direction gain difference is set to the value obtained by subtracting from the maximum value the setting value (e.g., in the case of MAX_F = 1 kHz, the setting data at 2 kHz) at the frequency one point higher than MAX_F (Step S30). The normal direction is assumed to be the direction from MAX_F toward MIN_F. It is assumed herein that MAX-F > MIN_F, MAX_F is 1 kHz, and MIN_F is 500 Hz, and that the normal direction is the direction toward the frequency lower than MAX_F and the reversal direction is the direction toward the frequency higher than MAX_F. When BAND_NO is judged other than "0", i.e., when one or more filters have been estimated relative to the setting data, the normal direction gain difference is set to the value obtained by subtracting from the maximum value the absolute error at the setting frequency one point lower than MAX_F, and the reversal direction gain difference is set to the value obtained by subtracting from the maximum value the absolute error at the setting frequency one point higher than MAX_F (Step S31). Next, the provisional bandwidth is set to the difference value between the center frequency fo = MAX_F and the setting frequency one point lower than MAX_F (Step S32).

If the notch filter is selected at Step S28, it is checked whether BAND_NO is "0" (Step S33). If "0", the normal direction gain difference is set to the value obtained by subtracting from the minimum value the setting value at the frequency one point higher than MIN_F, and the reversal direction gain difference is set to the value obtained by subtracting from the minimum value the setting value at the frequency one point lower than MIN_F (Step S34). If BAND_NO is judged other than "0", the normal direction gain difference is set to the value obtained by subtracting from the minimum value the absolute error at the setting frequency one point higher than MIN_F, and the reversal direction gain difference is set to the value obtained by subtracting from the minimum value the absolute error at the setting frequency one point lower than MIN_F (Step S35). Next, the provisional bandwidth is set to the difference value between the center frequency fo = MIN_F and the setting frequency one point higher than MIN_F (Step S36).

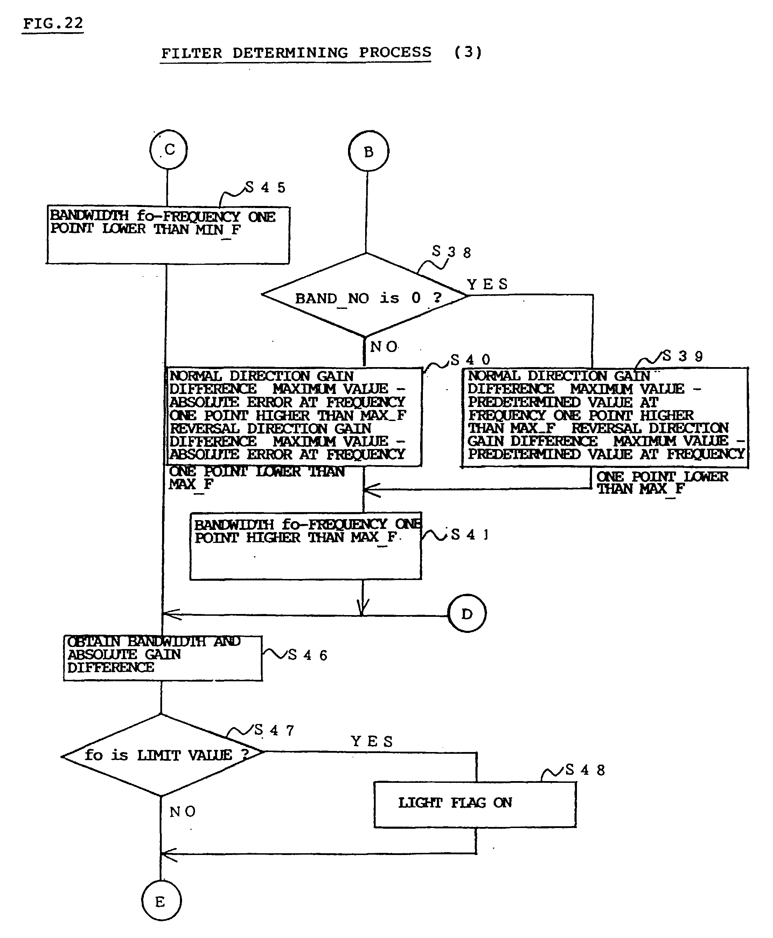

If the frequency taking the maximum value is judged at Step S27 smaller than the frequency taking the minimum value (MAX_F < MIN_F), it is then checked at Step S37 shown in Fig.20 whether the peaking filter was selected. If the peaking filter was selected, the process sequence advances to the flow chart shown in Fig.22 to check whether BAND_NO is "0" (Step S38). If "0", the normal direction gain difference is set to the value obtained by subtracting from the maximum value the setting value at the frequency one point higher than MAX_F, and the reversal direction gain difference is set to the value obtained by subtracting from the maximum value the setting value at the frequency one point lower than MAX_F (Step S39). If BAND_NO is judged other than "0", the normal direction gain difference is set to the value obtained by subtracting from the maximum value the absolute error at the setting frequency one point higher than MAX_F, and the reversal direction gain difference is set to the value obtained by subtracting from the maximum value the absolute error at the setting frequency one point lower than MAX_F (Step S40). Next, the provisional bandwidth is set to the difference value between the center frequency fo = MAX_F and the setting frequency one point higher than MAX_F (Step S41).

If it is judged at Step S37 that the notch filter was selected, it is checked whether BAND_NO is "0" (Step S42). If "0", the normal direction gain difference is set to the value obtained by subtracting from the minimum value the setting value at the frequency one point lower than MIN_F, and the reversal direction gain difference is set to the value obtained by subtracting from the minimum value the setting value at the frequency one point higher than MIN_F (Step S43). If BAND_NO is judged other than "0", the normal direction gain difference is set to the value obtained by subtracting from the minimum value the absolute error at the setting frequency one point higher than MIN_F, and the reversal direction gain difference is set to the value obtained by subtracting from the minimum value the absolute error at the setting frequency one point higher than MIN_F (Step S44). Next, the provisional bandwidth is set to the difference value between the center frequency fo = MIN_F and the setting frequency one point lower than MIN_F (Step S45).

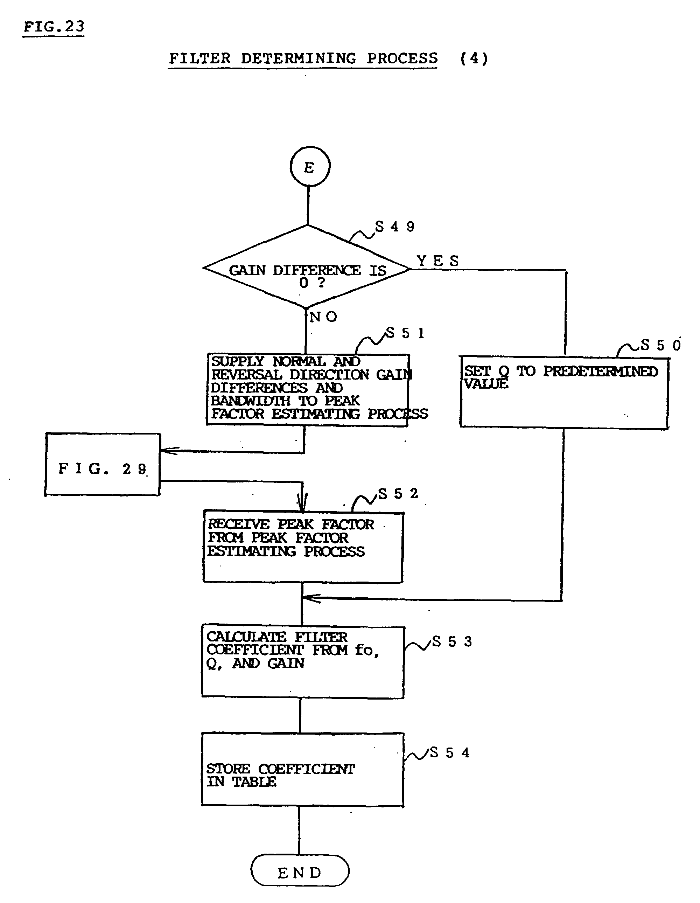

The absolute values of the normal and reversal direction gain differences and provisional bandwidth are obtained (Step S46) to determine the filter to be set. It is first checked whether the center frequency fo is a setting limit value (e.g., 60 Hz or 16 kHz at the opposite ends of the setting frequency points shown in Fig.30). If it is judged as the setting limit value, a limit FLAG indicating such a state is turned on (Step S48). Next, it is checked if the normal direction gain difference is "0" (Step S49). If "0", the normal and reversal gain differences and bandwidth are passed to the peak factor estimating flow (Fig.29) (Step S51). In the peak factor estimating flow, in accordance with the received normal and reversal gain differences and provisional bandwidth, the value of Q is estimated through the fuzzy estimation and passed to the filter determining process (Fig.23). The fuzzy estimation in this case will be described later. In the filter determining process, the value of Q is received (Step S52). Next, the filter weight coefficients are calculated from fo, Q, and GAIN (Step S53). The weight coefficients are stored in the coefficient table (Step S54) to thereafter terminate the filter determining process.

The peak factors of the filters estimated by the filter determining process for the setting data shown in Fig.30 are as follows.

For the filter BAND_NO = 0 with the maximum value = 8, minimum value = 2, MAX_F = 60 Hz, and MIN_F = 120 Hz, the peaking filter type is selected with the settings of fo = 60 Hz and GAIN = 8 dB. Calculated are the normal direction gain difference = 6 dB, reversal direction gain difference = 0 dB, and provisional bandwidth = 60 Hz with the limit FLAG being turned on. Therefore, Q is estimated as 1.75.

For the filter BAND_NO = 1 with the maximum value = 8, minimum value = 8, MAX_F = 8 kHz, and MIN_F = 8 kHz, the peaking filter type is selected with the settings of fo = 8 kHz and GAIN = 8 dB. Calculated are the normal direction gain difference = 0 dB, reversal direction gain difference = 0 dB, and provisional bandwidth = 4 kHz with the limit FLAG being turned off. Therefore, Q is estimated as 0.5.

For the filter BAND_NO = 2 with the maximum value = 6 dB, minimum value = 0 dB, MAX_F = 250 Hz, and MIN_F = 60 Hz, the peaking filter type is selected with the settings of fo = 250 Hz and GAIN = 6 dB. Calculated are the normal direction gain difference = 5 dB, reversal direction gain difference = 2 dB, and provisional bandwidth = 130 Hz with the limit FLAG being turned off. Therefore, Q is estimated as 0.82.

Error Calculating Process (Figs.24 to 26)

The error calculating process at Steps S4 and S10 is in detail to execute the processes illustrated in Figs.24 to 26. Referring to Fig.24, the setting frequency range is divided into bands each defined by three setting frequency points, to evaluate each band (Step S55). For the evaluation of each band, the process of obtaining the following values is executed (Step S56). The values to be obtained include the absolute error given by the equation (1), a sum of absolute values, the converted setting value and approximate value given by the equation (2), the relative error given by the equation (3), a sum of relative errors of each band, the maximum absolute and relative error values, the minimum absolute and relative error values, the frequency taking the maximum relative error, and the frequency taking the minimum relative error.

It is then checked whether the setting values are within the range from - 6 dB to + 6 dB (Step S58). If within this range, it is checked whether the relative error is 0.08 or smaller at the setting frequency point (Step S59). If 0.08 or smaller, the approximation at this setting frequency point is terminated (Step S60). If it is judged that the relative error is outside of the range from - 6 dB to + 6 dB, it means that the setting value is large. Accordingly, it is judged whether the relative error at the setting point is relatively large 0.15 or smaller (Step S61). If 0.15 or smaller, the approximation at this setting frequency point is terminated (Step S62).

Next, referring to Fig.25, the band having the maximum relative error is obtained (Step S63). CHK_END is turned off (Step S64). It is checked whether all the bands have been checked or CHK_END is on (Step S65). If neither of the conditions is satisfied, the following processes are performed starting from the band having a larger sum of relative errors. It is checked whether the maximum relative error is within the range from 0.16 to 0.39 (Step S66). If within this range, it is checked whether there is a filter having the center frequency fo within the band (Step S67). If there is such a filter, MOVE_NO at the control unit is set to the number of the band now in check, the center frequency is shifted in the manner described later, and CHK_END is turned on (Step S68). If there is no filter having the center frequency fo within the range or if the relative error is outside of the range from 0.16 to 0.39, the band having the next largest error is checked (Step S68).

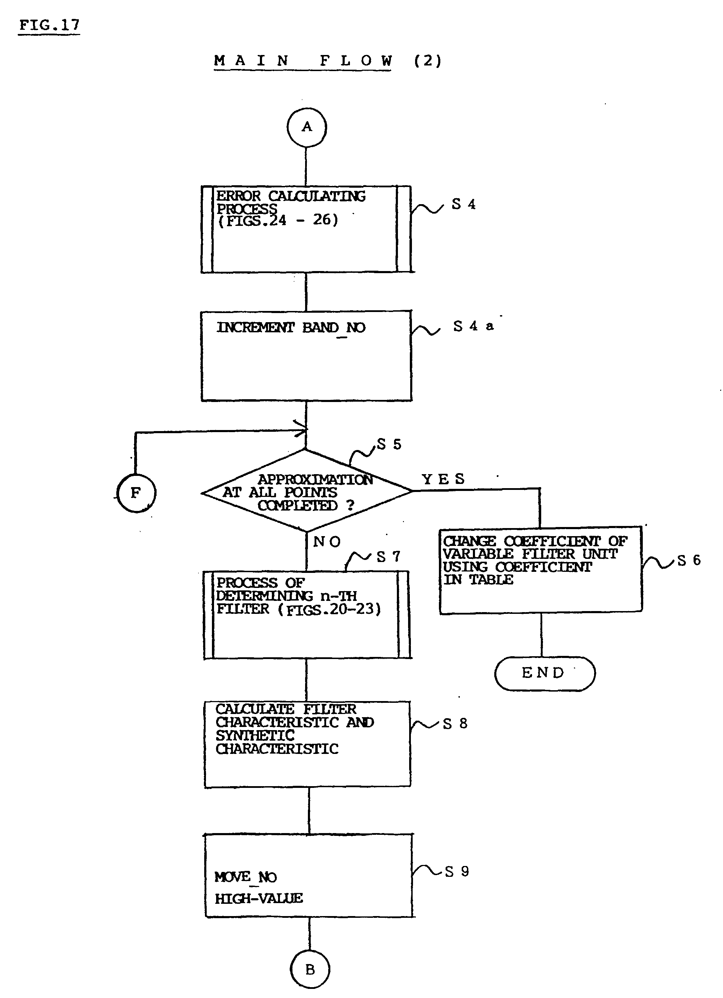

Next, at Step S70 shown in Fig.26, using the values at the band having the largest sum of relative errors, the maximum value is set to the maximum absolute error, the minimum value is set to the minimum absolute value, the frequency taking the maximum value is set to the frequency taking the maximum relative error, and the frequency taking the minimum value is set to the frequency taking the minimum relative error. After preparing for setting the next filter, the error calculating process (Step S4 in Fig.17) is terminated.

The contents of the error calculating process for the example of the setting data shown in Fig.30 are as follows. In this case, the setting frequency characteristic range is divided into the low band of 60 Hz, 120 Hz, and 250 Hz, the middle band of 500 Hz, 1 kHz, and 2 kHz, and the high band of 4 kHz, 8 kHz, and 16 kHz.

For the second filter BAND_NO = 0, the sum of absolute errors is 44. In the low band, the sum of relative errors = 0.382, the maximum relative error = 0.316, the maximum absolute error = 6 dB, the minimum relative error = 0.0, the minimum absolute error = 0 dB, the frequency taking the maximum relative error = 350 Hz, and the frequency taking the minimum relative error = 60 Hz. In the middle band, the sum of relative errors = 0.706, the maximum relative error = 0.235, the maximum absolute error = 4 dB, the minimum relative error = 0.235, the minimum absolute error = 4 dB, the frequency taking the maximum relative error = 500 Hz, and the frequency taking the minimum relative error = 500 Hz. In the high band, the sum of relative errors = 1.143, the maximum relative error = 0.381, the maximum absolute error = 8 dB, the minimum relative error = 0.381, the minimum absolute error = 8 dB, the frequency taking the maximum relative error = 8 kHz, and the frequency taking the minimum relative error = 8 kHz. From these data, the high band has the maximum sum of relative errors, with the maximum value = 8 dB, minimum value = 8 dB, MAX_F = 8 kHz, and MIN_F = 8 kHz. Namely, the second filter to be next set is corrected relative to the high band.

For the first filter BAND_NO = 1, the sum of absolute errors is 16. In the low band, the sum of relative errors = 0.382, the maximum relative error = 0.316, the minimum relative error = 0.0, the minimum absolute error = 0 dB, the frequency taking the maximum relative error = 250 Hz, and the frequency taking the minimum relative error = 60 Hz. In the middle band, the sum of relative errors = 0.106, the maximum relative error = 0.235, the maximum absolute error = 4 dB, the minimum relative error = 0.235, the minimum absolute error = 4 dB, the frequency taking the maximum relative error = 500 Hz, and the frequency taking the minimum relative error = 500 Hz. In the high band, the sum of relative errors = 0.190, the maximum relative error = 0.095, the maximum absolute error = 2 dB, the minimum relative error = 0.048, the minimum absolute error = 1 dB, the frequency taking the maximum relative error = 16 kHz, and the frequency taking the minimum relative error = 8 kHz. From these data, the middle band has the maximum sum of relative errors, with the maximum value = 6 dB, minimum value = 0 dB, MAX_F = 250 Hz, and MIN_F = 60 Hz. Namely, the third filter to be next set is corrected relative to the middle band.

For the third filter BAND_NO = 2, the sum of absolute errors is 10. In the low band, the sum of relative errors = 0.100, the maximum relative error = 0.052, the maximum absolute error = 1, the minimum relative error = 0.0, the minimum absolute error = 0, the frequency taking the maximum relative error = 120 Hz, and the frequency taking the minimum relative error = 60 Hz. In the middle band, the sum of relative errors = 0.165, the maximum relative error = 0.059, the maximum absolute error = 1, the minimum relative error = 0.053, the minimum absolute error = - 1, the frequency taking the maximum relative error = 250 Hz, and the frequency taking the minimum relative error = 500 Hz. In the high band, the sum of relative errors = 0.190, the maximum relative error = 0.095, the maximum absolute error = 1, the minimum relative error = 0.048, the minimum absolute error = 2, the frequency taking the maximum relative error = 4 kHz, and the frequency taking the minimum relative error = 16 kHz. After setting the filter BAND-NO = 2, the approximation at all setting frequency points falls within the predetermined allowable range, and the filter setting is terminated.

## Center Frequency Estimating Process (Figs.27 and 28)

In the center frequency estimating process, the center frequency is shifted. After receiving the frequency f* having the maximum error and the center frequency fo obtained at Step S16 of the main flow of the controlling process, the center frequency estimating process starts. First, which center frequency is shifted to what amount is determined from the properties of the setting data and errors. Referring to Fig.27, it is first checked whether the setting values are within the range from - 6 dB to + 6 dB (Step S71). If within this range, it is checked whether the relative error at the frequency f* is 0.1 or smaller (Step S72). If 0.1 or smaller, MOVE-WIDE representing the shift amount of the center frequency is set to the value of 1/30 CT which is the interval between the setting frequency points (Step S73). If larger than 0.1, it is then checked whether the relative error is 0.15 or larger (Step S74). If 0.15 or larger, MOVE_WIDE is set to 10 CT (Step S75). If smaller, MOVE_WIDE is set to 2/30 CT (Step S76). If it is judged that the setting values are not within the range from - 6 dB to + 6 dB, it is checked whether the relative error is 0.2 or smaller (Step S77). If 0.2 or smaller, MOVE_WIDE is set to 1/30 CT (Step S78). If larger, it is then checked whether the relative value is 0.25 or larger (Step S79). If 0.25 or larger, MOVE_WIDE is set to 10 CT (Step S80). If smaller, MOVE_WIDE is set to 2/30 CT (Step S81).

Referring to Fig.28, to determine the shift direction, it is first checked whether the approximate value is smaller than the setting value (Step S82). If smaller, it is checked whether the center frequency fo is higher than the frequency f* having the maximum error (Step S83). If higher, it is checked whether the filter is the peaking filter (Step S84). If it is the peaking filter, the new fo is set to the value obtained by subtracting MOVE_WIDE from the initial fo (Step S85). If the filter is judged as the notch filter, the new fo is set to the value obtained by adding MOVE_WIDE to the initial fo (Step S86). If the center frequency fo is judged lower than f*, it is then checked whether the filter is the peaking filter (Step S87). If it is the peaking filter, the new fo is set to the value obtained by adding MOVE_WIDE to the initial fo (Step S88). If it is judged as the notch filter, the new fo is set to the value obtained by subtracting MOVE_WIDE from the initial fo (Step S89).

If it is judged that the approximate value is larger than the setting value, it is then checked whether the center frequency fo is higher than the frequency f* having the error (Step S90) (Step S90). If higher, it is then checked whether the filter is the peaking filter (Step S91). If it is the peaking filter, the new fo is set to the value obtained by adding MOVE_WIDE to the initial fo (Step S92). If it is judged that the filter is the notch filter, the new fo is set to the value obtained by subtracting MOVE_WIDE from the initial fo (Step S93). If it is judged that the center frequency fo is lower, it is then checked whether the filter is the peaking filter (Step S94). If it is the peaking filter, the new fo is set to the value obtained by adding MOVE_WIDE to the initial fo (Step S96).

In this manner, after estimating the new fo, this new fo is passed to the control process (Step S97) to terminate the center frequency estimating process.

For the example of the setting data shown in Fig.30, this estimating process is executed only for the filter MOVE_NO = 0, obtaining fo = 60 Hz, the frequency f* having the maximum error = 250 Hz, the setting value = 6 dB, the approximate value = 0 dB, and the relative error = 0.316. Since the selected filter type is the peaking filter, the new fo is fo + 1 OCT = 120 Hz.

Peak Factor estimating Process (Fig.29)

In the peak factor estimating process in the filter determining process, the peak factor Q is estimated through the fuzzy estimation to be described later, by using as the input values the normal and reversal direction gain differences and provisional bandwidth obtained at Step S51 in the filter determining process (Step S98). It is checked whether the limit FLAG is on (Step S99). If not on, it is then checked whether the reversal direction gain difference is larger than the normal direction gain difference (Step S100). If larger, it is necessary to correct the estimated Q so that the correction value is set to the value of log (1.9 * |reversal direction gain difference - normal direction gain difference |) + 1.1, and the estimated Q is multiplied by the correction value to obtain the final Q (Step S101). If it is judged smaller at Step S100, it is then checked whether the setting value at fo of the filter BAND_NO is within the range from - 6 dB to + 6 dB (Step S102). If within this range, it is checked if Q is 1.0 or higher (Step S103). If higher, it is also necessary to correct the estimated Q so that the correction value is set to the value of log (1.5 * | reversal direction gain difference|), and the estimated Q is multiplied by the correction value to obtain the final Q (Step S104). If the limit FLAG is on at Step S105, the limit FLAG is turned off (Step S105). The estimated Q is passed to the control unit (Step S106) to terminate the peak factor estimating process.

In the example shown in Fig.30, the contents of the above process are as follows. For the filter BAND_NO = 0, there are obtained the normal direction gain difference = 6 dB, the reversal direction gain difference = 0 dB, and the provisional bandwidth = 60 Hz, resulting in the Q value of 1.75. Since the limit FLAG is on, it is turned off and the value Q is passed to the filter determining process.

For the filter BAND_NO = 2, there are obtained the normal direction gain difference = 5 dB, the reversal direction gain difference = 0 dB, and the provisional bandwidth = 130 Hz, resulting in the Q value of 0.82. Since the normal direction gain difference is larger than the reversal direction gain difference, the value Q is passed to the filter determining process without any correction.

Obtaining Peak Factor (Q) through Fuzzy Estimation

The fuzzy rules of the fuzzy estimation method are shown in Table 1, for the case where the peak factor of the filter is estimated using as the input values the center frequency and provisional bandwidth or frequency width obtained at Step S118 shown in Fig.6 of the first embodiment.

Table 1:

| Fuzzy rules for the estimation of Q | | | | | | | | |
|---|---|---|---|---|---|---|---|---|
| Frequency width | Center frequency (fo) | | | | | | | |
| (FRQ_WIDE) | VL | L | ML | MM | M | MH | H | VH |
| VN | M | MH | | | | | | |
| N | | MH | H | | | | | |
| MN | | MM | M | MH | | | | |
| MM | | | L | MM | MH | | | |
| M | | L | M | MH | MH | | | |
| MW | | | L | MM | M | MH | | |
| W | | | | M | M | M | MH | H |
| VW | | | | M | M | M | M | MH |

The meanings of the symbols of the fuzzy sets representing Q in Table 1 are:

| | |
|---|---|
| VL (Very Low) | very low |
| L (Low) | low |
| MM (More or Less Medium) | more or less medium |
| M (Medium) | medium |
| H (High) | high |
| VH (Very High) | very high |

The meanings of the symbols of the fuzzy sets representing frequency width are:

| | |
|---|---|
| VN (Very Narrow) | very narrow |
| N (Narrow) | narrow |
| MN (More or Less Narrow) | more or less narrow |
| MM (More or Less Medium) | more or less medium |
| M (Medium) | medium |
| MW (More or Less Wide) | more or less wide |
| W (Wide) | wide |
| VW (Very Wide) | very wide |

The meanings of the symbols of the fuzzy sets representing center frequencies are:

| | |
|---|---|
| VL (Very Low) | very low |
| L (Low) | low |
| ML (More or Less Low) | more or less low |
| MM (More or Less Medium) | more or less medium |
| M (Medium) | medium |
| MH (More or Less High) | more or less high |
| H (High) | high |
| VH (Very High) | very high |

Examples of statements of some rules shown in Table 1 are given below.

(Example 1) If FRQ_WIDE is Very Narrow and fo is Very Low, then Q is Medium.
(Example 2) If FRQ_WIDE is Very Narrow and fo is Low, then Q is More or less High.

Using the fuzzy rules, the value Q is estimated.
The fuzzy rules of the fuzzy estimation method are shown in Table 2, for the case where the peak factor of the filter is estimated using as the input values the normal direction gain difference and provisional bandwidth or frequency width obtained at Step S98 of Fig.29 of the second embodiment.

Table 2:

| Fuzzy rules for the estimation of Q | | | | |
|---|---|---|---|---|
| Normal Direction GAin Difference (POSI_AMP_WIDE) | Frequency width (FRQ_WIDE) | | | |
| | N | M | W | VW |
| S | L 1 | ML | ML | VL |
| L | H 2 | VH | H | M |

The meanings of the symbols of the fuzzy sets representing Q in Table are:

| | |
|---|---|
| VL (Very Low) | very low |
| L (Low) | low |
| ML (More or Less Low) | more or less low |
| M (Medium) | medium |
| H (High) | high |
| VH (Very High) | very high |

The meanings of the symbols of the fuzzy sets representing frequency width are:

| | |
|---|---|
| N (Narrow) | narrow |
| M (Medium) | medium |
| W (Wide) | wide |
| VW (Very Wide) | very wide |

The meanings of the symbols of the fuzzy sets representing normal direction gain differences are:

S (Small)     small
L (Large)     large

Examples of statements of some rules shown in Table 2 are given below.

(Example 1) If FRQ_WIDE is Narrow and POSI_AMP_WIDE is Small, then Q is Low.
(Example 2) If FRQ_WIDE is Narrow and POSI_AMP_WIDE is Large, then Q is High.

The grade values of the frequency width (FRQ_WIDE) and normal direction gain difference (AMP_WIDE) are obtained from the fuzzy sets of the frequency width shown in Fig.39 and the fuzzy sets of the normal direction gain difference. Using the fuzzy rules, the value Q is estimated.

Examples of Filter Structure

The structure of a digital filter suitable for the equalizer of the present invention is shown in Fig.42. In Fig.42, reference numerals 101 to 104 represent a sampling time interval delay element, reference numerals 105 to 111 represent a weight multiplier for coefficients A to E and $K_1$ and $K_2$, reference numerals 112 and 113 represent an adder, reference numeral 114 represents a unit for inputting parameters including a desired center frequency and filter gain, and reference numeral 116 represents a ROM for storing the filter weight coefficients A to E. Reference numeral 115 represents an unit for reading a suitable weight coefficient from ROM in response to the inputted center frequency and gain, and calculating the filter correction coefficients $K_1$ and $K_2$ to control the filter. These elements may be configured using either software or hardware. The transfer function of the filter is given by the following equations.

$$H(Z) = (AZ^{-2} + BZ^{-1} + C)/(BZ^{-2} + EZ^{-1} + 1) K_1 + K_2$$

$$k_1 = (1 - 10\beta/20)/(1 - 10\alpha/20)$$

$$K_2 = 1 - K_1$$

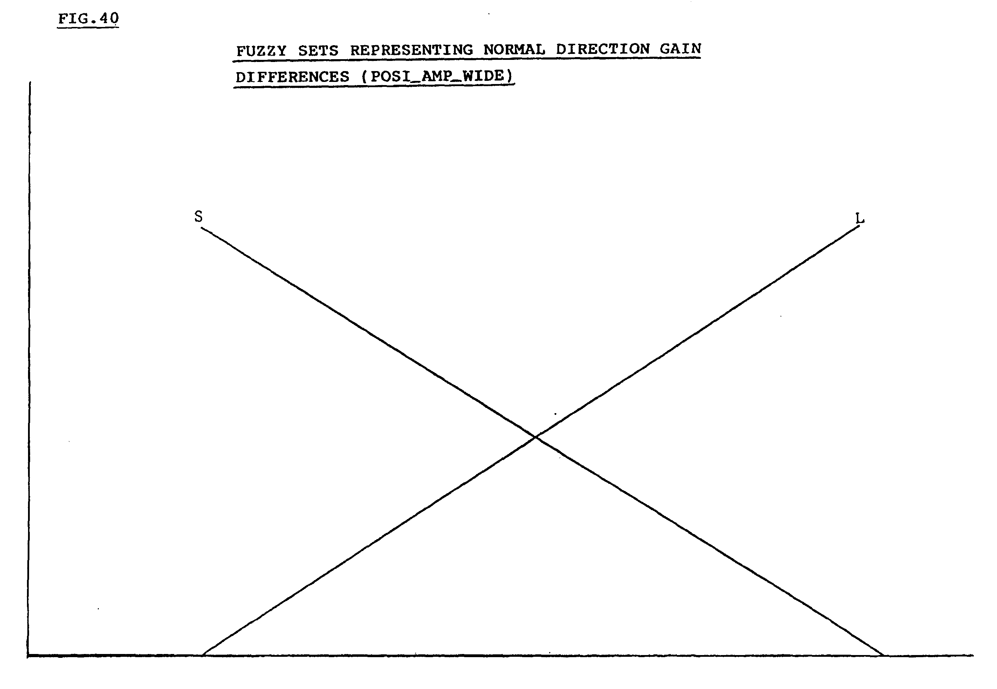

where $\alpha$ represents a reference gain value, and $\beta$ represents an inputted desired gain value. Consider for example a reference filter (i.e., $K_1 = K_2 = 1.0$) having the center frequency of 1 kHz, the peak factor Q of 1.0, and the gain $\alpha$ of 12 dB. The weight coefficients A to E of the reference filter read from ROM are given below, and the frequency characteristic is shown in Fig.40.

| A | B | C | D | E |
|---|---|---|---|---|
| 0.68852 | -1.85594 | 1.18642 | 0.87493 | -1.85594 |

The values $K_1$ and $K_2$ for changing the gain $\beta$ of the reference filter to 10 dB are given by:

$$K_1 = (1 - 10^{10/20})/(1 - 10^{12/20}) = 0.72533$$

$$K_2 = 1 - K_1 = 0.27467$$

Fig.43 shows the frequency characteristic of the filter having the weight coefficients A to E and the values $K_1$ and $K_2$ obtained for $\beta$ = 10, 8, 6, 4, and 2 dB. A desired characteristic of the filter can be calculated from a set of the filter weight coefficients A to E stored in ROM and the values $K_1$ and $K_2$ calculated from the inputted gain value $\beta$. Even if the number of filter weight coefficients becomes large, it is sufficient only to calculate the two coefficients $K_1$ and $K_2$, allowing to set a filter at high speed.

In the structure shown in Fig.42, the multipliers 110 and 111 and the adder 113 may be omitted to transform the filter to a general double second order transfer function. In this case, in obtaining the values $K_1$ and $K_2$, the weight coefficients used are A'= $A*K_1 + D*K_2$, B' = B, C' = $C*K_1 + K_2$, D' = D, and E' = E.

**Claims**

1. A frequency characteristic compensating apparatus comprising:

   variable filter means (4) including a plurality of filters capable of variably setting the filter coefficient parameters defining the center frequency, peak factor, and gain or attenuation,

   means (1) for setting as setting data a gain at each of a plurality of setting frequency points for a desired frequency response which is to be determined by said variable filter means (4),

   processor means (2) for determining the coefficient parameters, defining the center frequency, peak factor, and gain or attenuation of each filter to be set in accordance with the gain at each setting frequency point,

   memory means for storing the coefficient parameters determined by the processor means (2), and means (3) for supplying the coefficient parameters contained in the memory means to the variable filter means (4).

2. The apparatus of claim 1, wherein said processor means (2) is adapted to estimate the peak factor of each filter based on a processor determined center frequency and a provisional bandwidth thereof.

3. The apparatus of claim 1, wherein said processor means (2) includes a peak factor estimating unit for estimating the peak factor taking into consideration a difference between the maximum or minimum gain and the gain at a setting frequency point near the maximum or minimum gain.

4. The apparatus of claim 3, wherein the bandwidth is based on said set gains.

5. The apparatus of any preceding claim, wherein said variable filter means (4) is a digital filter of a variable gain for filtering an input signal in accordance with a predetermined transfer function, said digital filter comprising storage means (16) for storing multiplication factors calculated from a reference gain value, input means (14) for inputting said parameter defining said gain, and calculating means (15) for calculating at least one multiplication factor of said transfer function in accordance with said gain corresponding to said parameter inputted from said input means (14) and said reference gain, and wherein said multiplication factor(s) calculated by said calculating means (15) and said multiplication factor(s) stored in said storage means (16) are respectively supplied to multipliers (5 to 8).

6. The apparatus of any of claims 1 to 4, wherein said variable filter means (4) is a digital filter of a variable gain for filtering an input signal in accordance with a predetermined transfer function, said digital filter comprising storage means (16) for storing multiplication factors calculated from a reference gain value, input means (14) for inputting said parameter defining said gain, and calculating means (15) for calculating a coefficient from said gain corresponding to said parameter inputted from said input means (14) and said reference gain, and correcting some of said multiplication factors stored in said storage means (16) in accordance with said calculated coefficient, and wherein said multiplication factors corrected by said calculating means (15) and said multiplication factors not corrected and stored in said storage means (16) are respectively supplied to multipliers (5 to 8).

7. The apparatus of claim 1, wherein said processor means (2) selects as a center frequency one among said plurality of setting frequency points which has a maximum or minimum value of the gains set by said setting means (1), for the first filter to be set in said variable filter means (4).

8. The apparatus of claim 7, wherein said processor means (2) further selects as a center frequency another one among said plurality of setting frequency points which has a maximum value in the difference between gains set by said setting means (1) and gains of the first filter, for the second fitter to be set in said variable filter means (4).

9. The apparatus of claim 8, wherein the number of the set filters is less than that of said plurality of setting frequency points.

**Patentansprüche**

1. Einrichtung zur Kompensation einer Frequenzcharakteristik mit:

einer variablen Fittervorrichtung (4), welche eine Vielzahl von Filtern enthält, die in der Lage sind, die die Zentralfrequenz, Spitzenfaktor und Verstärkung oder Dämpfung definierenden Filterkoeffizentenparameter variabel einzustellen,

einer Vorrichtung (1) zum Einstellen einer Verstärkung an jedem einer Vielzahl von Sollwertfrequenzpunkten als Sollwertdaten für einen gewünschten Frequenzgang, weicher durch die variable Filtervorrichtung (4) zu bestimmen ist,

einer Prozessorvorrichtung (2) zum Bestimmen der Koeffizientenparameter, welche die oder den gemäß der Verstärkung an jedem Sollwertfrequenzpunkt einzustellende oder einzustellenden Zentralfrequenz, Spitzenfaktor und Verstärkung oder Dämpfung jedes Filters definieren,

einer Speichervorrichtung zum Abspeichem der von der Prozessorvorrichtung (2) bestimmten Koeffizientenparameter und einer Vorrichtung (3) zum Zuleiten der in der Speichervorrichtung enthaltenen Koeffizientenparameter an die variable Filtervorrichtung (4).

2. Einrichtung nach Anspruch 1, bei der die Prozessorvorrichtung (2) darauf abgestimmt ist, den Spitzenfaktor jedes Filters auf der Grundlage einer prozessorbestimmten Zentralfrequenz und einer vorläufigen Bandbreite davon abzuschätzen.

3. Einrichtung nach Anspruch 1, bei der die Prozessorvorrichtung (2) eine Spitzenfaktorabschätzeinheit zum Abschätzen des Spitzenfaktors unter Berücksichtigung einer Differenz zwischen der maximalen oder minimalen Verstärkung und der Verstärkung an einem Sollwertfrequenzpunkt nahe der maximalen oder minimalen Verstärkung aufweist.

4. Einrichtung nach Anspruch 3, bei der die Bandbreite auf den eingestellten Verstärkungen beruht.

5. Einrichtung nach einem der vorausgehenden Ansprüche, bei der die variable Filtervorrichtung (4) ein digitaler Filter variabler Verstärkung zum Filtern eines Eingangssignals gemäß einer vorbestimmten Transferfunktion ist, wobei der digitale Filter eine Speicherungsvorrichtung (16) zum Abspeichem von aus einem Referenzverstärkungswert berechneten Muftiplikationsfaktoren, eine Eingabevorrichtung (14) zum Eingeben des die Verstärkung definierenden Parameters, und eine Berechnungsvorrichtung (15) zum Berechnen zumindest eines Multiplikationsfaktors der Transferfunktion gemäß der dem von der Eingabevorrichtung (14) eingegebenen Parameter entsprechenden Verstärkung und der Referenzverstärkung aufweist, und bei der der oder die von der Berechungsvorrichtung (15) berechnete(n) Multiplikationsfaktor(en) und der oder die in der Speicherungsvorrichung (16) abgespeicherte(n) Multiplikationsfaktor(en) jeweils Multiplizierem (5 bis 8) zugeführt werden.

6. Einrichtung nach einem der Ansprüche 1 bis 4, bei der die variable Filtervorrichtung (4) ein digitaler Filter variabler Verstärkung zum Filtern eines Eingangssignals gemäß einer vorbestimmten Transferfunktion ist, wobei der digitale Filter eine Speicherungsvorrichtung (16) zum Abspeichern von aus einem Referenzverstärkungswert berechneten Multiplikationsfaktoren, eine Eingabevorrichtung (14) zum Eingeben des die Verstärkung definierenden Parameters, und eine Berechnungsvorrichtung (15) zum Berechnen eines Koeffizienten aus der dem von der Eingabevorrichtung (14) eingegebenen Parameter entsprechenden Verstärkung und der Referenzverstärkung und zum Korrigieren einiger der in der Speicherungsvorrichtung (16) gemäß des berechneten Koeffizienten abgespeicherten Multiplikationsfaktoren aufweist, und bei der die von der Berechungsvorrichtung (15) korrigierten und die nicht korrigierten und in der Speicherungsvorrichung (16) abgespeicherten Multiplikationsfaktoren jeweils Multiplizierern (5 bis 8) zugeführt werden.

7. Einrichtung nach Anspruch 1, bei dem die Prozessorvorrichtung (2) eine unter der Vielzahl von Sollwertfrequenzpunkten, welche eine maximalen oder minimalen Wert der von der Einstellvorrichtung (1) eingestellten Verstärkungen aufweist, für den ersten in der variablen Filtervorrichtung (4) einzustellenden Filter als eine Zentralfrequenz auswählt.

8. Einrichtung nach Anspruch 7, bei der die Prozessorvorrichtung (2) weiterhin eine andere unter der Vielzahl von Sollwertfrequenzpunkten, welche einen maximalen Wert in der Differenz zwischen von der Einstellvorrichtung (1) eingestellten Verstärkungen und Verstärkungen des ersten Filters aufweist, für den zweiten in der variablen Filtervorrichtung (4) einzustellenden Filter als eine Zentralfrequenz auswählt.

EP 0 571 635 B1

**9.** Einrichtung nach Anspruch 8, bei der die Anzahl der eingestellten Filter geringer ist als die der Vielzahl von Sollwertfrequenzpunkten.

**Revendications**

**1.** Dispositif de compensation de caractéristique fréquentielle comprenant :

des moyens formant filtre variable (4) comprenant une pluralité de filtres capables de régler de manière variable les paramètres des coefficients de filtrage définissant la fréquence centrale, le facteur de crête et le gain ou l'atténuation,
des moyens (1) pour régler, en tant que données de réglage, un gain pour chacun d'une pluralité de points de fréquence de réglage pour une réponse en fréquence souhaitée qui doit être déterminée par lesdits moyens formant filtre variable (4),
des moyens formant processeur (2) pour déterminer les paramètres des coefficients, définissant la fréquence centrale, le facteur de crête et le gain ou l'atténuation de chaque filtre devant être réglé conformément au gain pour chaque point de fréquence de réglage,
des moyens de mémorisation pour mémoriser les paramètres des coefficients déterminés par les moyens formant processeur (2), et des moyens (3) pour délivrer les paramètres des coefficients contenus dans les moyens de mémorisation aux moyens formant filtre variable (4).

**2.** Dispositif selon la revendication 1, dans lequel lesdits moyens formant processeur (2) sont adaptés pour estimer le facteur de crête de chaque filtre sur la base d'une fréquence centrale déterminée par le processeur et d'une bande passante provisoire de celui-ci.

**3.** Dispositif selon la revendication 1, dans lequel lesdits moyens formant processeur (2) comprennent une unité d'estimation de facteur de crête pour estimer le facteur de crête en prenant en considération une différence entre le gain maximum ou minimum et le gain pour un point de fréquence de réglage proche du gain maximum ou minimum.

**4.** Dispositif selon la revendication 3, dans lequel la bande passante est basée sur lesdits gains réglés.

**5.** Dispositif selon l'une quelconque des revendications précédentes, dans lequel lesdits moyens formant filtre variable (4) sont un filtre numérique à gain variable pour filtrer un signal d'entrée conformément à une fonction de transfert prédéterminée, ledit filtre numérique comprenant des moyens de mémorisation (16) pour mémoriser des facteurs de multiplication calculés à partir d'une valeur de gain de référence, des moyens d'entrée (14) pour entrer ledit paramètre définissant ledit gain, et des moyens de calcul (15) pour calculer au moins un facteur de multiplication de ladite fonction de transfert conformément audit gain correspondant audit paramètre entré par lesdits moyens d'entrée (14) et audit gain de référence, et dans lequel ledit ou lesdits facteurs de multiplication calculés par lesdits moyens de calcul (15) et ledit ou lesdits facteurs de multiplication mémorisés dans lesdits moyens de mémorisation (16) sont respectivement délivrés à des multiplicateurs (5 à 8).

**6.** Dispositif selon l'une quelconque des revendications 1 à 4, dans lequel lesdits moyens formant filtre variable (4) sont un filtre numérique à gain variable pour filtrer un signal d'entrée conformément à une fonction de transfert prédéterminée, ledit filtre numérique comprenant des moyens de mémorisation (16) pour mémoriser des facteurs de multiplication calculés à partir d'une valeur de gain de référence, des moyens d'entrée (14) pour entrer ledit paramètre définissant ledit gain, et des moyens de calcul (15) pour calculer un coefficient à partir dudit gain correspondant audit paramètre entré par lesdits moyens d'entrée (14) et dudit gain de référence, et corriger certains desdits facteurs de multiplication mémorisés dans lesdits moyens de mémorisation (16) conformément audit coefficient calculé, et dans lequel lesdits facteurs de multiplication corrigés par lesdits moyens de calcul (15) et lesdits facteurs de multiplication non corrigés et mémorisés dans lesdits moyens de mémorisation (16) sont respectivement délivrés à des multiplicateurs (5 à 8).

**7.** Dispositif selon la revendication 1, dans lequel lesdits moyens formant processeur (2) sélectionnent, en tant que fréquence centrale, un point parmi ladite pluralité de points de fréquence de réglage qui a une valeur maximum ou minimum des gains réglés par lesdits moyens de réglage (1), pour le premier filtre à régler dans lesdits moyens formant filtre variable (4).

17

**8.** Dispositif selon la revendication 7, dans lequel lesdits moyens formant processeur (2) sélectionnent, en outre, en tant que fréquence centrale, un autre point parmi ladite pluralité de points de fréquence de réglage qui a une valeur maximum de différence entre des gains réglés par lesdits moyens de réglage (1) et des gains du premier filtre, pour le deuxième filtre à régler dans lesdits moyens formant filtre variable (4).

**9.** Dispositif selon la revendication 8, dans lequel le nombre des filtres réglés est inférieur à celui de ladite pluralité de points de fréquence de réglage.

EP 0 571 635 B1

FIG.1

Block diagram:

- 1 INPUT UNIT → 2 MICROCOMPUTER → 3 INTERFACE UNIT → 4 fo,Q,GAIN (ATTENUATION) VARIABLE FILTER UNIT
- 2 MICROCOMPUTER → 5 DISPLAY UNIT
- ACOUSTIC SIGNAL INPUT → 6 ACOUSTIC SIGNAL INTERFACE UNIT
- ACOUSTIC SIGNAL OUTPUT
- S → 7 → 8
- 9 SIGNAL GENERATOR
- 10 → 11 ACOUSTIC CHARACTERISTIC MEASURING APPARATUS OBJECT CHARACTERISTIC DATA OUTPUT UNIT → 2

FIG.2

M A I N    F L O W  (1)

FIG.3

M A I N   F L O W  (2)

(A)

S7 — n FILTERS SET ?

YES

NO

S8
DETERMINE FILTER TYPE
ESTIMATE PEAK FACTOR
CALCULATE COEFFICIENT

S9
CORRECT CENTER FREQUENCY
OF FILTER AT BAND
(FIG.8)

S10
CALCULATE COEFFICIENT
USING CORRECTED CENTER
FREQUENCY

S11
CALCULATE FILTER
CHARACTERISTIC
CALCULATE SYNTHETIC
CHARACTERISTIC

S12
OBTAIN ERROR BETWEEN
SETTING DATA AND
SYNTHETIC CHARACTERISTIC

(C)

**FIG.4**

M A I N   F L O W   (3)

```
                    ( C )

           S13
      ╱ n FILTERS ╲    YES         ┌──────────────┐ S14
      ╲  SET ?   ╱ ──────────────► │ CHECK ERRORS │
          │                        │ IN BAND      │
          │ NO                     └──────────────┘
          │                               │
          │                        S15    │
          │              ╱ ERROR BEFORE ╲  YES
          │              ╲ CENTER FREQUENCY SHIFT ╲ ───────┐
          │               ╲ < ERROR AFTER SHIFT ? ╱        │
          │                      │                         │
          │                      │ NO                      │
          │              ┌──────────────┐ S16    ┌────────────────────┐ S17
          │              │ STORE COEFFICIENT │   │ OBTAIN COEFFICIENT │
          │              │ IN TABLE      │       │ BEFORE SHIFT FROM  │
          │              └──────────────┘        │ TABLE CALCULATE    │
          │                      │               │ FREQUENCY CHARACTE-│
          │                      │               │ RISTIC AT BAND     │
          │                      │               │ CALCULATE SYNTHETIC│
          │                      │               │ CHARACTERISTIC     │
          │                      │               └────────────────────┘
          │                      │               ┌────────────────┐ S18
          │                      │               │ TERMINATE SETTING │
          │                      │               │ AT BAND        │
          │                      │               └────────────────┘
          │                      │                       │
          │◄─────────────────────┴───────────────────────┘
          │
          │    S19
      ╱ BAND ╲        YES      ┌──────────────┐ S20
      ╱ WITH ERRORS ╲ ──────── │ TERMINATE    │
      ╲ 5dB PRESENT ? ╱        │ SETTING AT BAND │
          │                    └──────────────┘
          │ NO
        ( B )
```

22

FIG.5

PEAK FACTOR ESTIMATING PROCESS (1)

```
                      ┌─────────────┐
                      │    START    │
                      └─────────────┘
                             │
                             │                S 1 1 1
                          ╱─────────╲
                        ╱  MAXIMUM VALUE ╲
                      ╱ < MINIMUM VALUE OR BOTH ╲      YES
                      ╲  MAXIMUM AND MINIMUM VALUES ╱ ──────────┐
                        ╲  ARE NEGATIVE ?  ╱                     │
                          ╲─────────╱                           │
                             │                                  │
                            NO                                  │
                             │                                  │
                      ┌──────────────────┐ S 1 1 2   ┌──────────────────┐ S 1 1 3
                      │ SELECT PEAKING FILTER │       │ SELECT NOTCH FILTER │
                      │ CENTER FREQUENCY      │       │ CENTER FREQUENCY    │
                      │ FREQUENCY TAKING MAXIMUM │    │ FREQUENCY TAKING    │
                      │ VALUE                 │       │ MINIMUM VALUE       │
                      │ GAIN MAXIMUM VALUE    │       │ GAIN MINIMUM VALUE  │
                      └──────────────────┘           └──────────────────┘
                             │                                  │
                             │◄─────────────────────────────────┘
                             │
                      ┌──────────────────┐
                      │ GAIN DIFFERENCE   │
                      │ MAXIMUM VALUE - MINIMUM │ S 1 1 4
                      │ VALUE             │
                      └──────────────────┘
                             │
            S 1 1 5       ╱─────────╲        YES
                        ╱ GAIN < 3 dB ? ╲ ──────────┐
                          ╲─────────╱                │
                             │                       │
                            NO                       │
                             │                       │
                      ┌──────────────────┐ S 1 1 6   ┌──────────────────┐ S 1 1 7
                      │ PROVISIONAL BANDWIDTH │       │ PEAK FACTOR         │
                      │ FREQUENCY DIFFERENCE BETWEEN │ │ PREDETERMINED VALUE │
                      │ MAXIMUM AND MINIMUM VALUES │  └──────────────────┘
                      └──────────────────┘                  │
                             │                              ┌────┐
                           ┌────┐                           │ B B │
                           │ A A │                          └────┘
                           └────┘
```

**FIG.6**

PEAK FACTOR ESTIMATING PROCESS (2)

( A A )                                  ( B B )

S 1 1 8

INPUT CENTER FREQUENCY
AND PROVISIONAL
BANDWIDTH AND ESTIMATE
PEAK FACTOR THROUGH
FUZZY

S 1 1 9

CALCULATE FILTER
COEFFICIENT USING
CENTER FREQUENCY, PEAK
FACTOR, AND GAIN
(ATTENUATION)

S 1 2 0

STORE COEFFICIENT
IN TABLE

( E N D )

24

FIG.7

ERROR CALCULATE PROCESS

```
        ( S T A R T )
              │
              ▼
         ╱─────────╲           S 3 1 1
        ╱  ALL FREQUENCY ╲      Y E S
       ╱   RANGE HAS       ╲──────────┐
       ╲   COMPLETED ?     ╱          │
        ╲                 ╱           │
         ╲───────────────╱            │
              │                       │
            N O                       │
              │                       │
              ▼            S 3 1 2     │
  ┌───────────────────────┐           │
  │ DIVIDE INTO BANDS      │           │
  │ OBTAIN  ERRORS BETWEEN │           │
  │ SETTING DATA AND       │           │
  │ SYNTHETIC              │           │
  │ CHARACTERISTIC AT BAND,│           │
  │ MAXIMUM AND MIMIMUM    │           │
  │ ERRORS,                │           │
  │ FREQUENCIES TAKING     │           │
  │ MAXIMUM                │           │
  │ AND MINIMUM ERRORS     │           │
  └───────────────────────┘           │
              │                       │
              ◄───────────────────────┘
              ▼            S 3 1 3
  ┌───────────────────────┐
  │ CHECK BAND HAVING      │
  │ LARGEST ERRORS AND SET │
  │ MAXIMUM AND MINIMUM    │
  │ ERRORS, FREQUENCIES    │
  │ HAVING MAXIMUM AND     │
  │ MINIMUM ERRORS         │
  └───────────────────────┘
              │
              ▼
         ( E N D )
```

FIG.8

CENTER FREQUENCY CORRECTING PROCESS

FIG.9

SETTING DATA

| FREQUENCY[Hz] | GAIN [dB] |
|---|---|
| 6 0 | 8 |
| 120 | 2 |
| 250 | 6 |
| 500 | 4 |
| 750 | 4 |
| 1 k | 4 |
| 4 k | 7 |
| 8 k | 7 |
| 16 k | 7 |

FIG.10

FIG.11

27

FIG.12

FIG.13

FIG.14

FIG.15

(PRIOR ART)

FIG.16

M A I N   F L O W   (1)

START

INITIALIZE

SEARCH SETTING DATA
AND OBTAIN MAXIMUM
AND MINIMUM ERRORS
AND FREQUENCIES
TAKING MAXIMUM AND
MINIMUM ERRORS

S 1

PROCESS OF
DETERMINING FIRST
FILTER (FIGS.20 – 23)

S 2

CALCULATE FILTER
FREQUENCY CHARACTERI-
STIC AND SYNTHETIC
CHARACTERISTIC

S 3

A

EP 0 571 635 B1

FIG.17

M A I N  F L O W  (2)

A

ERROR CALCULATING
PROCESS
(FIGS.24 - 26)  — S 4

INCREMENT BAND_NO  — S 4 a

S 5
APPROXIMATION
AT ALL POINTS
COMPLETED ?

F

Y E S

N O

CHANGE COEFFICIENT OF
VARIABLE FILTER UNIT
USING COEFFICIENT
IN TABLE  — S 6

S 7
PROCESS OF
DETERMINING n-TH
FILTER (FIGS.20-23)

E N D

CALCULATE FILTER
CHARACTERISTIC AND
SYNTHETIC
CHARACTERISTIC  — S 8

MOVE_NO
HIGH-VALUE  — S 9

B

31

FIG.18

M A I N   F L O W  (3)

(B)

ERROR CALCULATING
PROCESS
(FIGS.24 – 26)                    S 1 0

MOVE_NO
IS HIGH_VALUE ?                   S 1 1

YES → (C)

NO

MAXIMUM ABSOLUTE
ERROR>MINIMUM
ABSOLUTE ERROR FOR
MOVE_NO ?                          S 1 2

NO

FREQUENCY HAVING ERROR
FREQUENCY HAVING MAXIMUM
ERROR                              S 1 3

FREQUENCY HAVING ERROR
FREQUENCY HAVING
MINIMUM ERROR                      S 1 4

SAVE PRESENT fo AND
SUM OF PRESENT
ABSOLUTE ERRORS                    S 1 5

SUPPLY FREQUENCY
HAVING ERROR AND fo
TO CENTER FREQUENCY
ESTIMATING PROCESS                 S 1 6

FIG.27

(D)

**FIG.19**                          M A I N  F L O W  (4)

D

| RECEIVE NEW CENTER FREQUENCY FROM CENTER FREQUENCY ESTIMATING PROCESS | S 1 7 |

| CALCULATE FILTER COEFFICIENT FROM fo,Q, AND GAIN | S 1 8 |

| CALCULATE CENTER SHIFTED FILTER CHARACTERISTIC AND SYNTHETIC CHARACTERISTIC | S 1·9 |

| OBTAIN SUM OF ABSOLUTE ERRORS | S 2 0 |

SUM OF ABSOLUTE ERRORS BEFORE fo SHIFT < AFTER SHIFT ?        S 2 1

YES

NO

S 2 2 a

| CALCULATE COEFFICIENT FROM SAVED fo,q,AND GAIN, AND CENTER SHIFTED FILTER CHARACTERISTIC AND SYNTHETIC CHARACTERISTIC |

| CHANGE COEFFICIENT IN TABLE FOR fo SHIFTED FILTER TO CALCULATED COEFFICIENT | S 2 2 |

C        E

| INCREMENT BAND NO | S 2 3 |

F

33

FIG.20

FILTER DETERMINING PROCESS (1)

## FIG.21

### FILTER DETERMINING PROCESS (2)

(A)

S28 — PEAKING FILTER ?
YES → S29 — BAND_NO is 0?
NO

YES → S30

**S30**

NORMAL DIRECTION GAIN DIFFERENCE MAXIMUM VALUE – PREDETERMINED VALUE AT FREQUENCY ONE POINT LOWER THAN MAX_F REVERSAL DIRECTION GAIN DIFFERENCE MAXIMUM VALUE – PREDETERMINED VALUE AT FREQUENCY ONE POINT HIGHER THAN MAX_F

S28: NO

**S31**

NORMAL DIRECTION GAIN DIFFERENCE MAXIMUM VALUE – ABSOLUTE ERROR AT FREQUENCY ONE POINT LOWER THAN MAX_F REVERSAL DIRECTION GAIN DIFFERENCE MAXIMUM VALUE – ABSOLUTE ERROR AT FREQUENCY ONE POINT HIGHER THAN MAX_F

**S32**

BANDWIDTH fo-FREQUENCY ONE POINT LOWER THAN MAX_F

(D)

**S33** BAND_NO is 0 ?
YES
NO

**S35**

NORMAL DIRECTION GAIN DIFFERENCE MINIMUM VALUE – ABSOLUTE ERROR AT FREQUENCY ONE POINT HIGHER THAN MIN_F REVERSAL DIRECTION GAIN DIFFERENCE MINIMUM VALUE – ABSOLUTE ERROR AT FREQUENCY ONE POINT LOWER THAN MIN_F

**S34**

NORMAL DIRECTION GAIN DIFFERENCE MINIMUM VALUE – PREDETERMINED VALUE AT FREQUENCY ONE POINT HIGHER THAN MIN_F REVERSAL DIRECTION GAIN DIFFERENCE MINIMUM VALUE – PREDETERMINED VALUE AT FREQUENCY ONE POINT LOWER THAN MIN_F

**S36**

BANDWIDTH fo-FREQUENCY ONE POINT HIGHER THAN MIN_F

(D)

FIG.22

## FILTER DETERMINING PROCESS (3)

EP 0 571 635 B1

FIG.23

FILTER DETERMINING PROCESS (4)

E

S 4 9

GAIN DIFFERENCE IS
0 ?

YES

NO

S 5 1

SUPPLY NORMAL AND
REVERSAL DIRECTION GAIN
DIFFERENCES AND
BANDWIDTH TO PEAK
FACTOR ESTIMATING PROCESS

S 5 0

SET Q TO PREDETERMINED
VALUE

FIG. 29

S 5 2

RECEIVE PEAK FACTOR
FROM PEAK FACTOR
ESTIMATING PROCESS

S 5 3

CALCULATE FILTER
COEFFICIENT FROM fo,
Q, AND GAIN

S 5 4

STORE COEFFICIENT
IN TABLE

END

37

EP 0 571 635 B1

**FIG.24**

ERROR CALCULATING PROCESS (1)

38

**FIG.25**

ERROR CALCULATING PROCESS (2)

**FIG.26**

ERROR CALCULATING PROCESS (3)

USING ERRORS AT BAND HAVING LARGEST SUM OF RELATIVE ERRORS, SET MAXIMUM AND MINIMUM ABSOLUTE ERRORS AND FREQUENCIES HAVING MAXIMUM AND MINIMUM RELATIVE ERRORS.

S 7 0

END

40

**FIG.27**

CENTER FREQUENCY ESTIMATING PROCESS (1)

```
                    ┌─────────────┐
                    │   START     │
                    └──────┬──────┘
                           │
                        ╱─────╲  S 7 1
                      ╱ SETTING  ╲      YES
                     ╱ VALUE      ╲──────────────────┐
                     ╲ WITHIN - 6dB╱                  │
                      ╲TO + 6 dB ? ╱               ╱─────╲  S 7 2
                        ╲────┬────╱              ╱ RELATIVE ╲    YES
                           NO                   ╱  ERROR    ╲────────┐
                            │                   ╲  < 0.1 ?  ╱        │
                        ╱─────╲  S 7 7            ╲────┬───╱      S 7 3
                      ╱RELATIVE╲     YES            NO             │
                     ╱  ERROR   ╲──────────┐         │      ┌──────────────────┐
                     ╲ < 0.2 ?  ╱          │         │      │MOVE_WIDE←1/3OCT   │
                       ╲───┬───╱        S 7 8         │      └────────┬─────────┘
                         NO    S 7 9  ┌──────────┐    │               │
                          │    │      │MOVE_WIDE │    │             ( A )
                        ╱─────╲       │←1/3OCT   │    │
                      ╱RELATIVE╲      └────┬─────┘  ╱─────╲  S 7 4
                     ╱  ERROR   ╲          │      ╱RELATIVE ╲    YES
                     ╲ > 0.25 ? ╱        ( A )   ╱  ERROR   ╲────────┐
                       ╲───┬───╱ YES             ╲ > 0.15 ? ╱        │
                     NO    │               ╲────┬───╱    S 7 5
              S 8 1   │    │                  NO          │
       ┌──────────┐   │  S 8 0              │    ┌──────────────┐
       │MOVE_WIDE │   │ ┌──────────┐        │    │MOVE_WIDE←1OCT│
       │ 2/3 OCT  │   │ │MOVE_WIDE │        │    └──────┬───────┘
       └────┬─────┘   │ │←1OCT     │        │           │
            │         │ └────┬─────┘    S 7 6│
            │         │      │     ┌──────────────┐
            │         │      │     │MOVE_WIDE     │
            │         │      │     │ 2/3 OCT      │
            │         │      │     └──────┬───────┘
            │         │      │            │
            │         │      └──────◄─────┤
            │         │                   │
            │       ( A )
            │
          ( B )
```

EP 0 571 635 B1

FIG.28

CENTER FREQUENCY ESTIMATING PROCESS (2)

FIG.29

PEAK FACTOR ESTIMATING PROCESS

START

S98
ESTIMATE PEAK FACTOR THROUGH FUZZY USING INPUT VALUES OF NORMAL DIRECTION GAIN DIFFERENCE AND BANDWIDTH

S99
CONTROL UNIT LIMIT FLAG_ON ?

YES

S105
CONTROL UNIT LIMIT FLAG_OFF

A

NO

S100
REVERSAL DIRECTION GAIN DIFFERENCE > NORMAL DIRECTION GAIN DIFFERENCE ?

YES

NO

S101
CORRECTION VALUE LOG(1.10 * (REVERSAL DIRECTION GAIN DIFFERENCE — NORMAL DIRECTION GAIN DIFFERENCE) + 1.1 Q Q * CORRECTION VALUE

A

S102
SETTING VALUE AT fo OF BAND NO WITHIN − 6 dB TO + 6 dB ?

NO

YES

S103
Q>1.0 ?

YES

NO

S104
CORRECTION VALUE LOG (1.5* (REVERSAL DIRECTION GAIN DIFFERENCE)

A

B

SEND PEAK FACTOR TO CONTROL UNIT

END

43

FIG.30

| FREQUEN POINT (Hz) | SENT VALUE (dB) |
|---|---|
| 6 0 | 8 |
| 1 2 0 | 2 |
| 2 5 0 | 6 |
| 5 0 0 | 4 |
| 1 k | 4 |
| 2 k | 4 |
| 4 k | 8 |
| 8 k | 8 |
| 1 6 k | 8 |

FIG.31

FIG.32

FIG.33

FIG.34

FIG.35

FIG.36

45

FIG.37

FIG.38

FIG.39

FUZZY SETS REPRESENTING FREQUENCY WIDTH (FRQ_WIDE)

FIG.40

FUZZY SETS REPRESENTING NORMAL DIRECTION GAIN
DIFFERENCES (POSI_AMP_WIDE)

EP 0 571 635 B1

FIG.41

FUZZY SETS REPRESENTING Q

V L    L    M L    M                    H         V H

EP 0 571 635 B1

FIG.42

FIG.43